# EUROPEAN PATENT SPECIFICATION

(11) **EP 4 593 550 B1**
(45) Date of publication and mention of the grant of the patent: **09.12.2026**
(21) Application number: 24194469.3
(22) Date of filing: 14.08.2024
(51) Int. Cl.: H10D 30/01, H10D 30/83, H10D 62/17, H10D 64/27, H10D 84/80

(54) **VERTICAL COUPLING CAPACITANCE GATE-CONTROLLED JUNCTION FIELD EFFECT TRANSISTOR AND MANUFACTURING METHOD THEREOF**
DURCH EIN GATE GESTEUERTER SPERRSCHICHT-FELDEFFEKTTRANSISTOR MIT VERTIKALER KOPPLUNG UND HERSTELLUNGSVERFAHREN DAFÜR
TRANSISTOR À EFFET DE CHAMP À JONCTION COMMANDÉE PAR GRILLE ET À CAPACITÉ DE COUPLAGE VERTICAL ET SON PROCÉDÉ DE FABRICATION

(30) Priority: 24.01.2024 CN 202410097603
(43) Date of publication of application: 30.07.2025
(73) Proprietor: Suzhou Watech Electronics Co., Ltd., Suzhou, Jiangsu 215125 (CN)
(72) Inventor: ZHANG, Xiaoyu, Suzhou, 215125 (CN); WANG, Changchang, Suzhou, 215125 (CN); YUE, Dancheng, Suzhou, 215125 (CN)
(74) Representative: Michalski Hüttermann & Partner mbB

(56) References cited:
- CN-A- 114 823 871
- US-A1- 2012 211 806
- US-A1- 2014 169 045

## Description

### TECHNICAL FIELD

The present disclosure relates to the technical field of semiconductors, and more particularly to a vertical junction field effect transistor (JFET) with a gate structure formed by a vertical coupling capacitance and a manufacturing method thereof.

### BACKGROUND

Silicon carbide (SiC) material is a three-generation wide band gap semiconductor material, the band gap of SiC is much higher than traditional silicon material (1.1 eV), the critical breakdown field strength of SiC is an order of magnitude higher than silicon material, SiC material has the advantage of bearing high temperature and high voltage, and the saturation drift velocity of SiC material is fast, SiC material is suitable for the manufacturing power semiconductor device with fast response and capable of bearing high temperature and high voltage, such as a vertical double-diffused MOSFET (VDMOS), a junction field-effect transistor (JFET) and so on. The junction field-effect transistor (JFET) is a three-port semiconductor device. The operating principle of the JEFT is controlling the reverse bias of the PN junction formed between the gate electrode and the channel by the voltage applied to the gate to realize the on-off of the drain electrode and the source electrode. In a case where no voltage is applied to the gate electrode, the JEFT is usually a normally-on device, and the conducting channel is inside the device. The JFET has the advantages of low noise, small size, and high-frequency response, often being applied to switching devices, power amplifiers, and digital electronic circuits to satisfy the requirements of different electronic devices.

The vertical double-diffused MOSFET (MOSFET) device is a vertical semiconductor device with the advantages of both bipolar transistors and conventional MOS devices. The gate and the source of VDMOS are located on the device surface, and the drain is located on the back of the device. The operation principle of the device is that the gate controls the on-off of the channel and the current flows from the drain electrode through the body and the inversion channel on the surface of the device to the source electrode. The conducting channel is on the surface of the device. The VDMOS, as an ideal power device in switching applications and linear applications, is mainly applied in electronic switches, adapters, drive band energy, industrial control, etc.

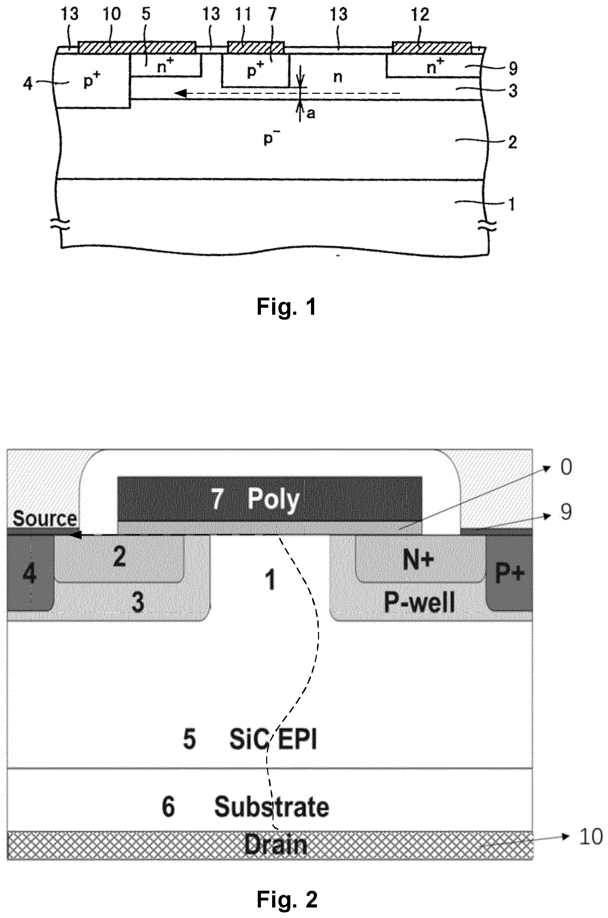

A JFET device according to patent No. CN1238904C, as shown in Fig. 1, comprises a monocrystalline silicon SiC substrate 1, a p- type epitaxial layer 2, an n- type epitaxial layer 3, a p+ type semiconductor layer 4, an n+ type source region layer 5, a p+ type gate region layer 7, an n+ type drain region layer 9, a source electrode 10, a gate electrode 11, and a drain electrode 12. The conducting channel of the JFET device is located inside the device and inside the n- type epitaxial layer 3. The conducting channel disposed inside the semiconductor material can avoid the problem of low mobility in the SiC material surface. Due to the JFET device being a normally-on device, that is, in a case where no voltage is applied to the p+ gate region layer 7 (i.e., gate electrode), the device is conducted (the current is represented by the dotted line in Fig. 1), and a negative voltage must be applied to the p+ type gate region layer 7 (i.e., gate electrode) to turn off the device, which limits the application as a power switch. The structure of the P+ type gate region layer 7 (i.e., the gate electrode) and the channel form a PN junction, and a voltage higher than 3V cannot be applied to the P+ type gate region layer 7 (i.e., the gate electrode). For SiC material, a voltage of 3V or more is applied to the gate electrode, the gate electrode and the channel are conducted or the gate electrode and the source electrode are conducted, and the conducting current strongly affects the current characteristic from the drain electrode to the source electrode. The gate electrode cannot be applied to a high voltage, which limits the application as a power switch.

Therefore, the gate electrode of the conventional silicon carbide-based junction field effect transistor cannot be applied to a higher voltage and has a low reliability limiting the application as a power switch, which are technical problems urgently needed to solve for one having ordinary skills in the art.

US2014169045A1 discloses a longitudinal bidirectional device in which current flows in a layering direction of a semiconductor layered portion formed on a front surface of a substrate, the bidirectional device comprising a first semiconductor element that includes a first channel and is formed on the semiconductor layered portion; and a second semiconductor element that includes a second channel and is provided on the substrate side of the first semiconductor element within the semiconductor layered portion. The first semiconductor element further includes a first control electrode that controls the first channel and that is formed on a surface of the semiconductor layered portion that faces away from the substrate, and the second semiconductor element is formed on at least a portion of the surface of the semiconductor layered portion on which the first control electrode is formed and includes a second control electrode that controls the second channel.

CN114823871A discloses a JFET, which includes a drain region; a drain terminal coupled to the drain region; an insulated electrode; and an insulated terminal coupled to the insulated electrode; where the JFET is provided with an active region; the insulated electrode presents a capacitor towards the drain terminal, and the capacitance value of the capacitor is between 0.1 nanofarads per square centimeter of the active region and 10 nanofarads per square centimeter of the transverse range of the active region.

US20120211806A1 discloses a normally-off JFET, which includes a channel region of a first conductivity type, a floating semiconductor region of a second conductivity type adjoining the channel region, and a contact region of the first conductivity type adjoining the floating semiconductor region. The floating semiconductor region is arranged between the contact region and the channel region.

The above information disclosed in the background is only for enhancing the understanding of the background of the present disclosure and thus may contain information that does not form the prior art known to one having ordinary skills in the art.

### SUMMARY

The embodiments of the present disclosure provided a vertical junction field effect transistor (JFET) with a gate structure formed by a vertical coupling capacitance and a manufacturing method thereof to solve the problems in the conventional silicon carbide-based junction field effect transistor device that the gate electrode cannot be applied to a higher voltage and has low reliability limiting the application as a power switch.

The invention is summarized by the appended set of claims.

The embodiments of the present disclosure have the following technical advantages due to the adoption of the above technical proposals.

In the vertical junction field effect transistor with a gate structure formed by a vertical coupling capacitance of the embodiment of the present disclosure, the top gate is indirectly controlled by the electrode spaced with the dielectric layer, the gate voltage applied to the electrode is coupled to the top gate by coupling. Since the top gate is floating which is not directly connected to the gate electrode, the electric potential of the electrode can be increased to more than 3V without causing the top gate, the portion of the base between the top gate and the bottom gate, and the portion of the base between the bottom gates conducted. Compared with the JFET device according to No. CN1238904C, the transistor of the embodiment of the present disclosure cannot be conducted even if a high voltage (more than 3V, e.g., 4V, 5V) is applied to the top gate, and which does not affect the current characteristic from the drain electrode to the source electrode. The top gate is indirectly controlled by the electrode spaced with the dielectric layer so that no current flows through the top gate and the reliability is high.

### BRIEF DESCRIPTION OF THE DRAWINGS

The drawings described herein are intended to provide a further understanding of the present disclosure and are incorporated in and constitute a part of this specification, schematic embodiments of the disclosure together with the description serve to explain the principles of the present disclosure, and do not constitute an improper limitation of the present disclosure. In the drawings:
Fig. 1 is a schematic diagram of a conventional JFET device.
Fig. 2 is a schematic diagram of a conventional SiC VDMOS device.
Fig. 3-1 is a schematic diagram of the first implementation of a vertical junction field effect transistor (JFET) with a gate structure formed by a vertical coupling capacitance according to the embodiment of the present disclosure.
Fig. 3-2 is a schematic diagram of the second implementation of the vertical junction field effect transistor (JFET) with a gate structure formed by a vertical coupling capacitance according to the present disclosure.
Fig. 3-3 is a schematic diagram of the third implementation of the vertical junction field effect transistor (JFET) with a gate structure formed by a vertical coupling capacitance according to the present disclosure.

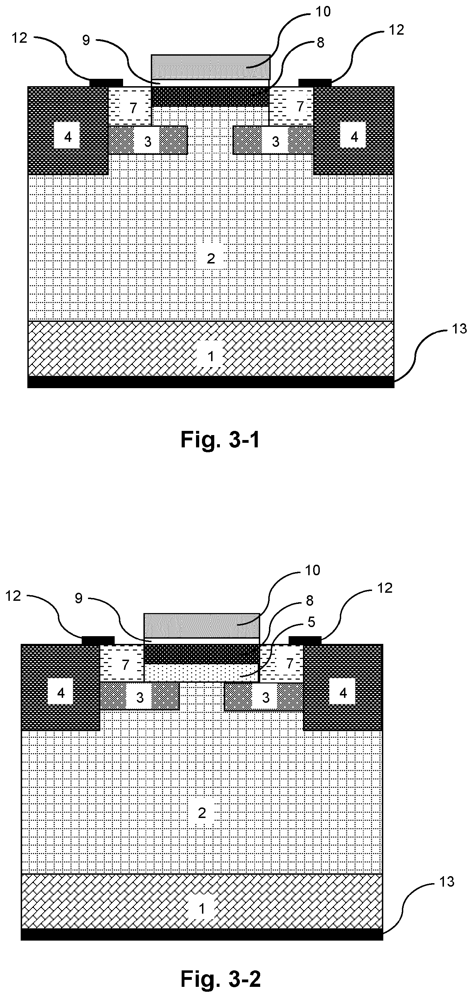

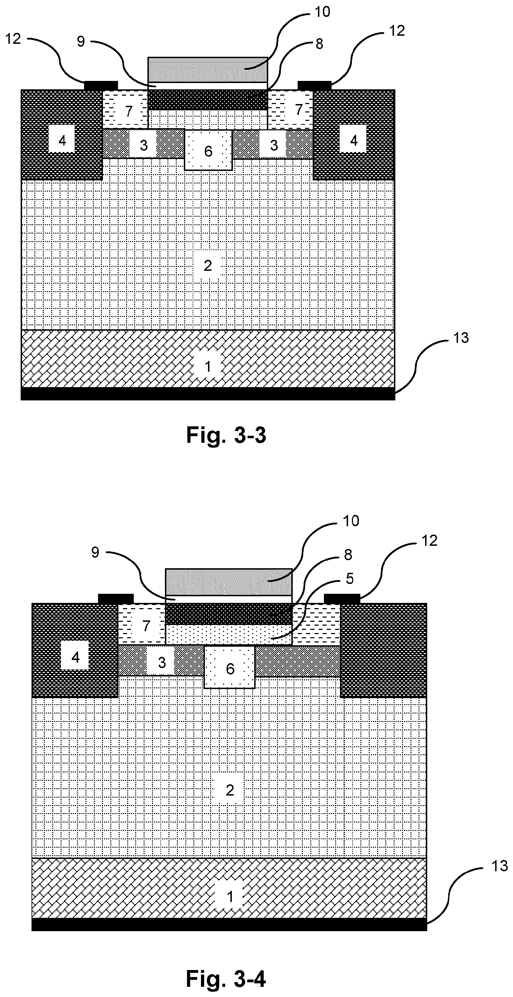

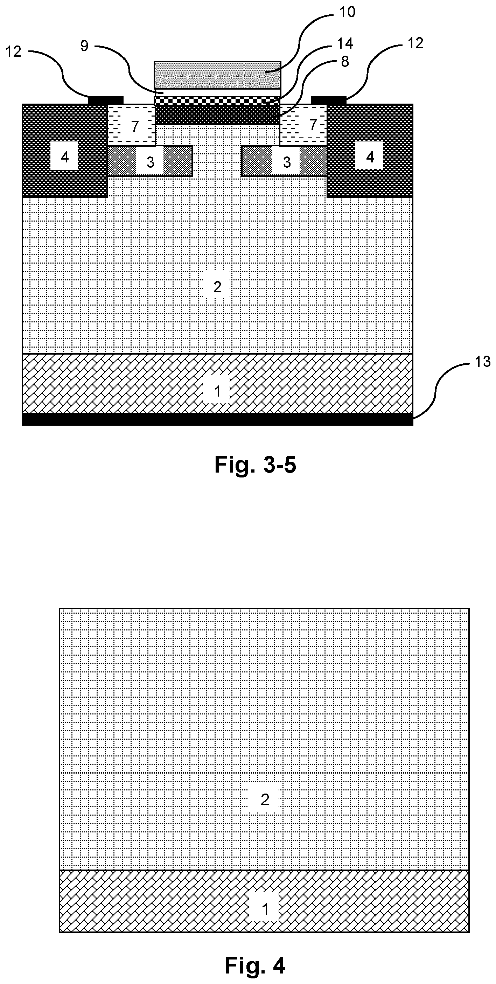

Fig. 3-4 is a schematic diagram of the fourth implementation of the vertical junction field effect transistor (JFET) with a gate structure formed by a vertical coupling capacitance according to the present disclosure.
Fig. 3-5 is a schematic diagram of the fifth implementation of the vertical junction field effect transistor (JFET) with a gate structure formed by a vertical coupling capacitance according to the present disclosure.
Fig. 4 is a schematic diagram of the manufacturing method of the fourth implementation of a vertical junction field effect transistor (JFET) with a gate structure formed by a vertical coupling capacitance according to the present disclosure, illustrating forming an epitaxial layer on the substrate.

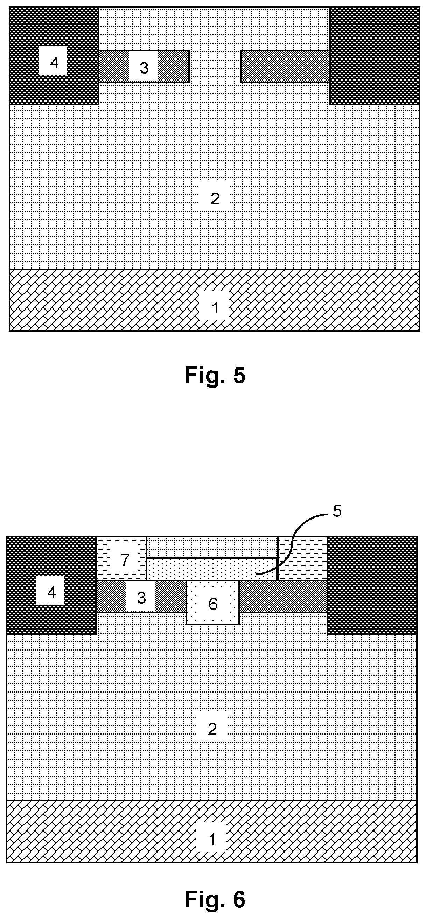

Fig. 5 is a schematic diagram, illustrating forming top gates and a second doping type ohmic contact regions based on Fig. 4.
Fig. 6 is a schematic diagram, illustrating forming a channel I, a channel II, and source regions based on Fig. 5.

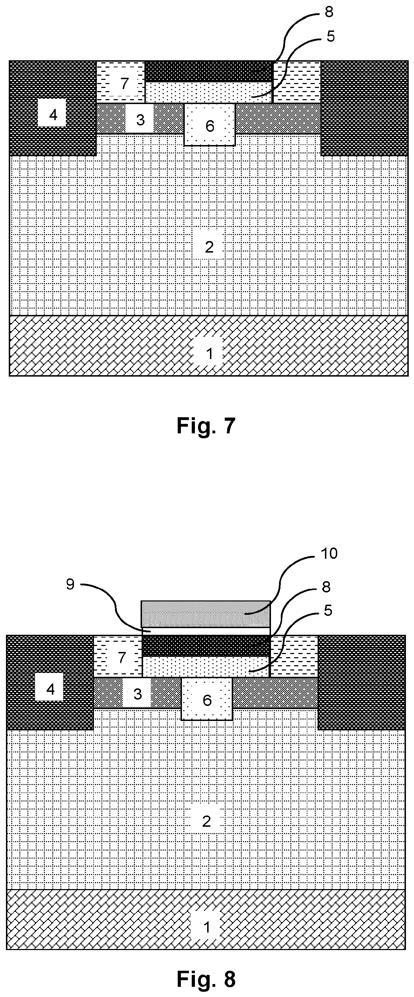

Fig. 7 is a schematic diagram, illustrating forming a top gate based on Fig. 6.
Fig. 8 is a schematic diagram, illustrating forming a dielectric layer and a coupling capacitance upper electrode based on Fig. 7.

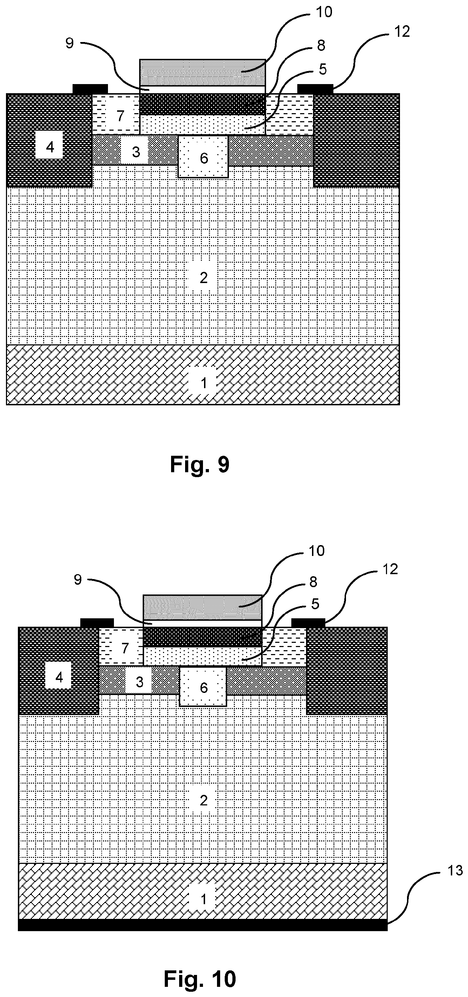

Fig. 9 is a schematic diagram, illustrating forming a gate electrode and source electrodes based on Fig. 8.
Fig. 10 is a schematic diagram, illustrating forming a drain electrode based on Fig. 9.

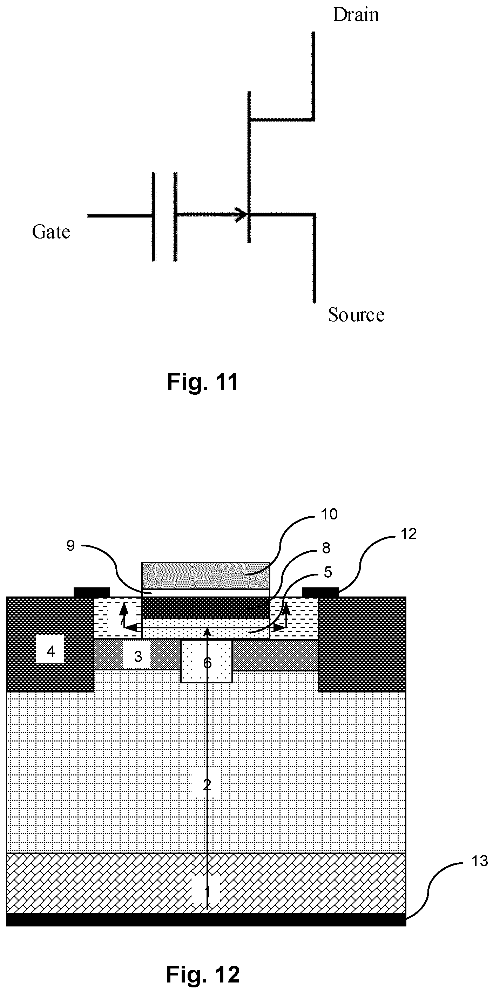

Fig. 11 is an equivalent circuit diagram of the vertical junction field effect transistor (JFET) with a gate structure formed by a vertical coupling capacitance according to the present disclosure.
Fig. 12 is a schematic diagram of the vertical junction field effect transistor (JFET) with a gate structure formed by a vertical coupling capacitance according to the present disclosure in a conducted state, illustrating a current path.

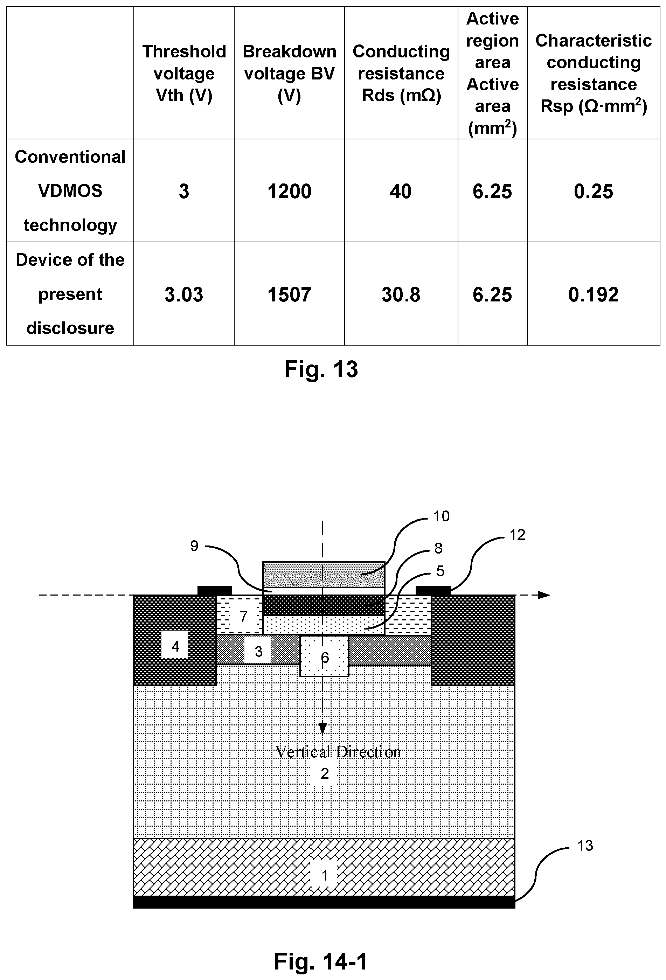

Fig. 13 is a comparison schematic diagram of the characteristics of the vertical junction field effect transistor (JFET) with a gate structure formed by a vertical coupling capacitance according to the present disclosure with the characteristics of the conventional VDMOS device.
Fig. 14-1 is a schematic diagram of the vertical junction field effect transistor (JFET) with a gate structure formed by a vertical coupling capacitance according to the present disclosure.

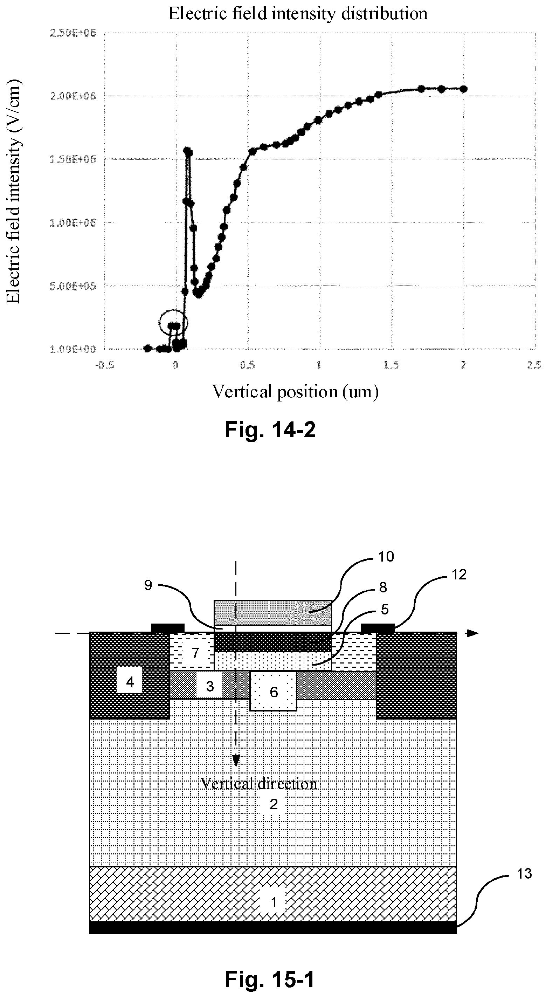

Fig. 14-2 is an internal electric field distribution diagram of the vertical junction field effect transistor (JFET) with a gate structure formed by a vertical coupling capacitance according to the present disclosure in a broken-down state.
Fig. 15-1 is a schematic diagram of the vertical junction field effect transistor (JFET) with a gate structure formed by a vertical coupling capacitance according to the present disclosure.

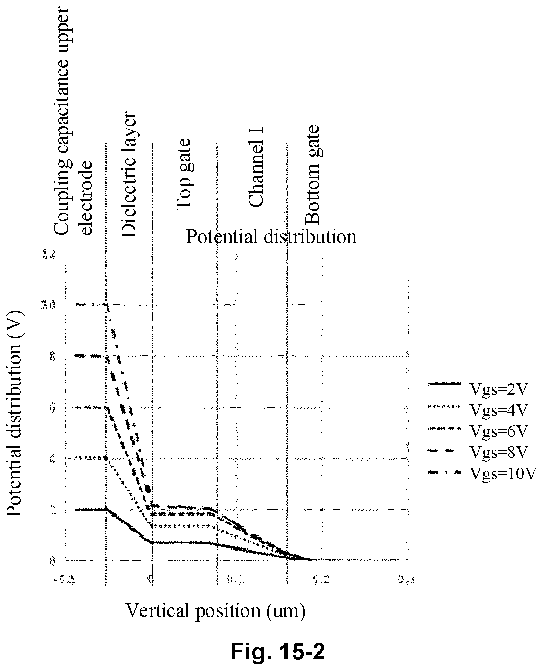

Fig. 15-2 is a potential distribution diagram of the gate electrode structure of the vertical junction field effect transistor (JFET) with a gate structure formed by a vertical coupling capacitance according to the present disclosure.

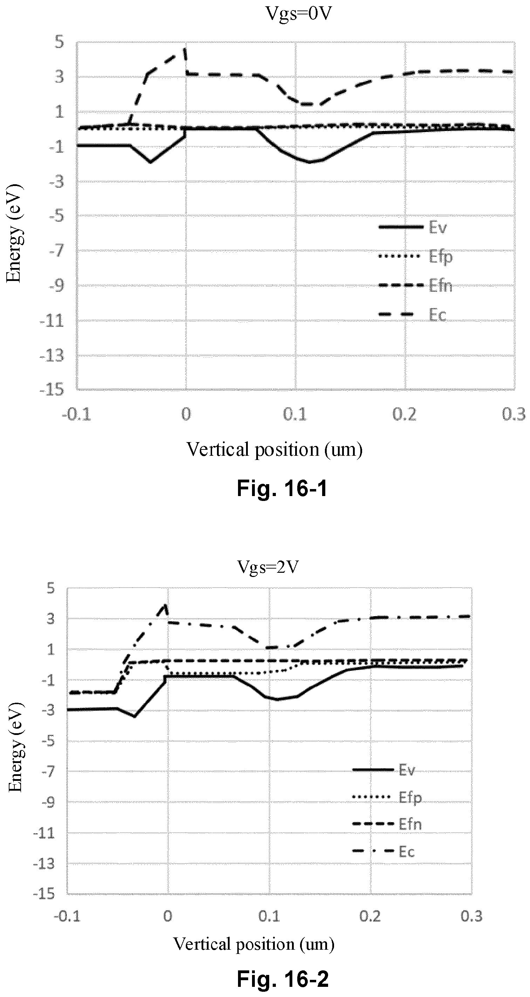

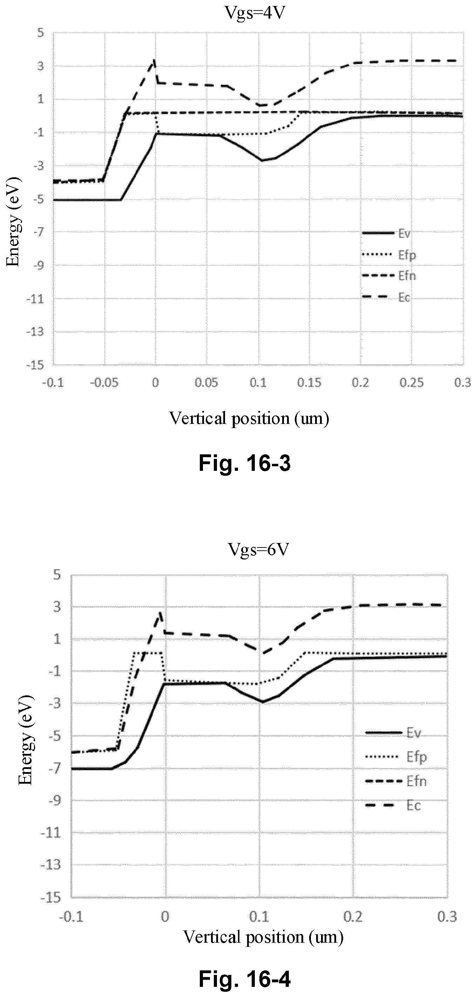

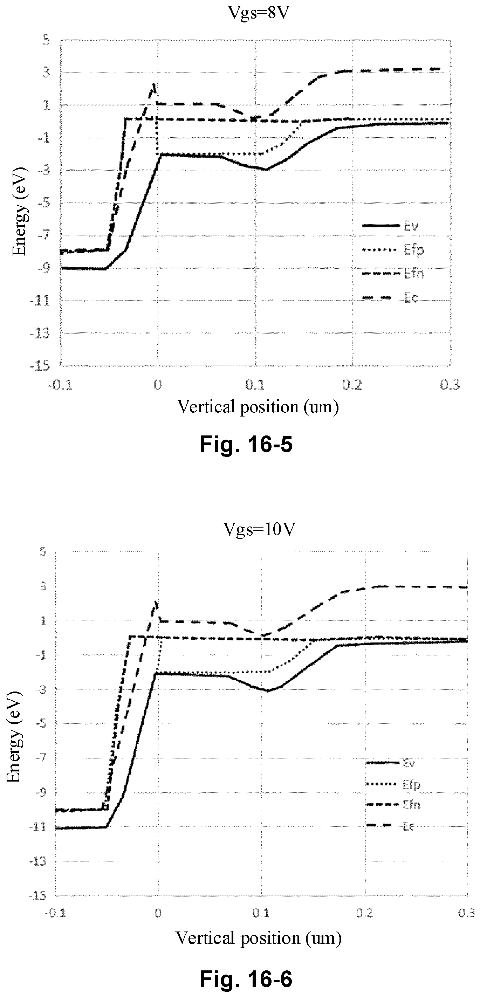

Figs. 16-1, 16-2, 16-3, 16-4, 16-5, and 16-6 are energy band distribution diagrams for different voltages applied to the coupling capacitance upper electrode of the vertical junction field effect transistor (JFET) with a gate structure formed by a vertical coupling capacitance according to the present disclosure.

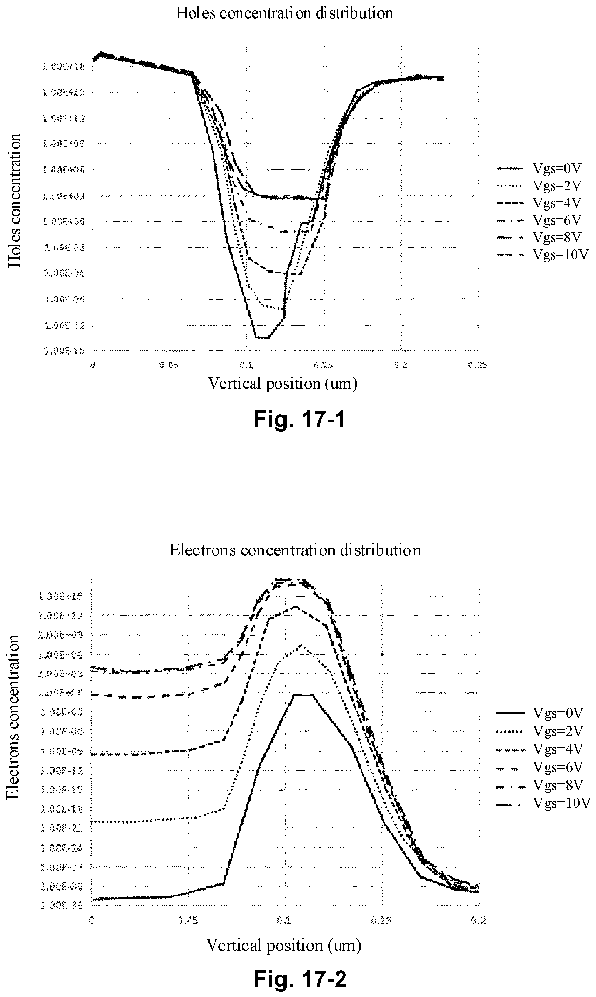

Fig. 17-1 is a carrier concentration distribution diagram in each region of the vertical junction field effect transistor (JFET) with a gate structure formed by a vertical coupling capacitance according to the present disclosure when working, illustrating the hole concentration in the top gate, the channel I, and the bottom gate affected by the voltage applied to the coupling capacitance upper electrode.
Fig. 17-2 is a carrier concentration distribution diagram in each region of the vertical junction field effect transistor (JFET) with a gate structure formed by a vertical coupling capacitance according to the present disclosure when working, illustrating the electron concentration in the top gate, the channel I, and the bottom gate affected by the voltage applied to the coupling capacitance upper electrode.

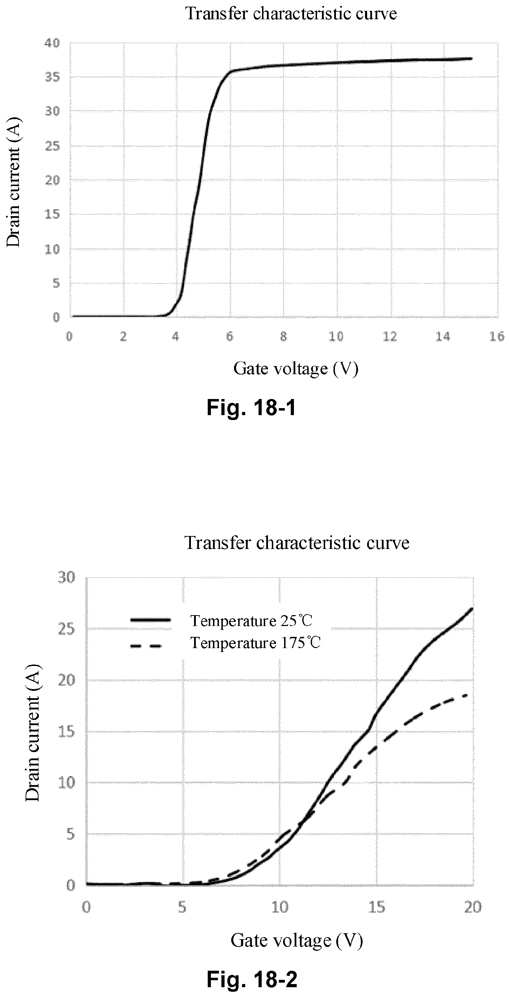

Fig. 18-1 is a transfer characteristic curve graph of the vertical junction field effect transistor (JFET) with a gate structure formed by a vertical coupling capacitance according to the present disclosure.
Fig. 18-2 is a transfer characteristic curve graph of a conventional SiC MOSFET device.

REFERENCES IN THE DRAWINGS:
substrate 1, epitaxial layer 2, bottom gate 3, second doping type ohmic contact region 4; channel I 5;
channel II 6, source region 7, top gate 8, dielectric layer 9; and
coupling capacitance upper electrode 10, source electrode 12, drain electrode 13, metal silicide layer 14.

### DETAILED DESCRIPTION OF THE EMBODIMENTS

In order to make technical solutions and advantages of embodiments of the disclosure clearer, exemplary embodiments of the disclosure are described in further detail below in combination with accompanying drawings. Obviously, the described embodiments are only part of the embodiments of the disclosure, not an exhaustive list of all embodiments.

Traditional semiconductor devices are often manufactured with the first-generation semiconductor material silicon. In recent years, the third-generation wide band gap semiconductor material silicon carbide has material advantages, such as wide band gap, high breakdown voltage, and high thermal conductivity, and the semiconductor device based on the third-generation semiconductor material silicon carbide has shown significant performance advantages over the semiconductor device based on silicon. However, at present, the growth of the silicon carbide material is immature, the semiconductor device based on silicon carbide material has performance and reliability problems, such as the low surface mobility of the silicon carbide material due to more surface defects near the silicon carbide material surface, seriously affecting the improvement of the device performance. The silicon carbide device requires high gate oxide, and the conventional gate oxide quality makes it difficult to satisfy the reliability requirements. For the same type of power device of the conventional technology, the conducting channel is disposed on the surface of the silicon carbide material and the oxide layer. Due to the silicon carbide material characteristic, many charges and defects is formed on the surface of the silicon carbide and the oxide layer affecting the carrier mobility in the channel, so that the carrier mobility of the channel is much lower than the body mobility of the silicon carbide material. The channel mobility of the silicon carbide MOSFET, i.e., the surface mobility, is in the range of 20cm²/V·s to 40cm²/V·s, and the body mobility of silicon carbide material is about 1000cm²/V·s. The low channel mobility affects the current transfer characteristics and the conducting resistance of the device. The portion of the flow through the surface of the device is disposed below the gate oxide, the operating reliability of the gate electrode in the device can be affected by the center of the unstable traps and defects.

For the same type of power device of the conventional technology, the vertical epitaxial layer-JFET region-dielectric layer is the main voltage-bearing region under the high drain electrode voltage (on the breakdown conditions) making the device off. According to the relationship D=ε·E among the electric displacement vector, the electric field intensity, the dielectric constant, the electric displacement vector in the semiconductor material is Dₛₑₘ=εₛₑₘ·Eₛₑₘ, the electric displacement vector in the dielectric layer immediately adjacent to the semiconductor material is D_{die}=ε_{die}·E_{die}, the electric displacement vector is continuous in the surface of the semiconductor material and the dielectric layer, that is, Dₛₑₘ=D_{die}, so εₛₑₘ·εₛₑₘ=ε_{die}·ε_{die}. In the case where the dielectric is immediately adjacent to the different semiconductor material, such as the substrates are silicon materials and the silicon carbide materials, the dielectric constant ε of the two semiconductor materials are essentially the same (ε_{Si}=11.8, ε_{SiC}=9.8), however, the critical breakdown field strength of the third-generation wide band gap semiconductor material silicon carbide is much larger than that of silicon carbide material (E_{Si}=0.23MV/cm, E_{SiC}=2.2MV/cm), and the electric field intensity within the dielectric layer of the silicon carbide is much larger than that of the silicon material because εₛₑₘ·Eₛₑₘ=ε_{die}·E_{die}. Therefore, the dielectric layer (oxide layer or high-k dielectric) under the gate has a high electric field intensity when the silicon-based device is in the breakdown state, the typical value is about 2×10⁶ V/cm, and the electric field intensity is on the order of megavolts per centimeter. The high electric field intensity within the dielectric layer affects the reliability of the gate electrode operation of the silicon-based device.

In conclusion, the conventional silicon carbide-based junction field effect transistor in conventional technology not only has a technical problem in that the gate electrode cannot be applied to a higher voltage and has a low reliability limiting the application as a power switch, but also has the technical problem about poor performance caused by the conducting channel being closed to the material surface with low mobility, and also has a technical problem of poor device reliability caused by a poor quality of the gate dielectric layer.

A SiC VDMOS device according to patent No. CN116598356A, as shown in Fig. 2, comprises a gate oxide layer 0, an N-type region 1, an N+ doping region 2, a channel region 3, an N-type ohmic contact region 4, a SiC epitaxial layer 5, a SiC substrate 6, a polycrystalline silicon 7, a source region 9, and a drain electrode 10. In a case where a voltage is not applied to the Poly polycrystalline silicon 7, the device is not conducted. In a case where a voltage is applied to the Poly polycrystalline silicon 7, by the capacitance effect of the metal oxide layer semiconductor, the channel region 3 near the surface attracts positive charges to form a surface inversion channel, realizing the conducting from the drain electrode to the source electrode, the current (represented by the dotted line in Fig. 2) first flow at the vertical direction from drain electrode to the interface between the SiC surface and the oxide on the SiC, then flow from the SiC surface inversion layer to the source electrode, that is, one part of the conducting channel is at the vertical direction and located inside the device, the other part of the conducting channel is at the lateral direction and along the surface of the device. The charges, defects, and the surface scattering at the interface of the semiconductor material and the oxide layer, the low effective mobility of the surface of the SiC VDMOS results in a low saturation current Idsat of the device and a high conducting resistance Rsp affecting the device performance and limiting the output power and switch speed of the device.

The present disclosure provides a vertical capacitive coupling gate-controlled junction field effect transistor. The vertical capacitive coupling gate-controlled junction field effect transistor of the present disclosure is in a vertical device structure.

### Embodiment 1

The first implementation of the vertical junction field effect transistor (JFET) with a gate structure formed by a vertical coupling capacitance according to the present disclosure, as shown in Fig. 3-1, comprises:
a base of a first doping type;
two bottom gate 3 of a second doping type, formed inside the base and spaced apart in the lateral direction;
a top gate 8 of the second doping type, formed inside the base, where the top gate 8 is located above the interval between the two bottom gates, and an interval is formed between the top gate 8 and the bottom gate 3;
a dielectric layer 9, formed on the base and located on the top gate 8; and
a coupling capacitance upper electrode 10, formed on the dielectric layer 9.

The top gate 8 is indirectly controlled by the coupling capacitance upper electrode 10 spaced with the dielectric layer 9.

The top gate 8 is in a floating state, and the coupling capacitance upper electrode 10, the dielectric layer 9, and the top gate 8 form a gate electrode structure of the vertical junction field effect transistor (JFET) with a gate structure formed by a vertical coupling capacitance as a whole.

A JFET region I is formed by the top gate 8 of the second doping type, a portion of the base between the top gate 8 and the bottom gate 3, and the bottom gate 3.

A JFET region II is formed by the two bottom gates 3 and a portion between the two gates 3.

The top gate 8 of the JFET region I is indirectly controlled by the coupling capacitance upper electrode 10 with the dielectric layer 9, so that the JFET region I and the JFET region II are controlled by the coupling capacitance upper electrode 10 spaced with the dielectric layer 9.

A portion of the base located between the top gate 8 and the bottom gate 3, and a portion of the base located between gates 3 are defined as a channel region as a whole.

In the vertical junction field effect transistor (JFET) with a gate structure formed by a vertical coupling capacitance of the embodiment of the present disclosure, the top gate 8 is indirectly controlled by the coupling capacitance upper electrode 10 spaced with the dielectric layer 9, the gate voltage applied to the coupling capacitance upper electrode 10 is coupled to the top gate 8 by coupling. Since the top gate 8 is in a floating state which is not directly connected to the gate electrode, the electric potential of the coupling capacitance upper electrode 10 can be increased to more than 3V without causing the portion of the base between the top gate 8 and the bottom gate 3, and the JFET region I and the JFET region II are not conducted. Compared with the JFET device according to patent No. CN1238904C, the transistor of the embodiment of the present disclosure cannot be conducted even if a high voltage (more than 3V, e.g., 4V, 5V) is applied to the top gate 8, and which does not affect the current characteristic from the drain electrode to the source electrode. The top gate 8 is indirectly controlled by the coupling capacitance upper electrode 10 spaced with the dielectric layer 9 so that no current flows through the top gate 8 and the reliability is high.

The portion between the top gate 8 and the bottom gate 3 remains as the base, which is a portion of the base between the top gate 8 and the bottom gate 3. The portion between the bottom gates 3 remains as the base, which is a portion of the base between the bottom gates 3.

The vertical junction field effect transistor (JFET) with a gate structure formed by a vertical coupling capacitance of the embodiments of the present disclosure is neither a conventional JFET device nor a conventional SiC VDMOS device, but a vertical junction field effect transistor (JFET) with a gate structure formed by a vertical coupling capacitance with a novel structure.

The essential difference between the vertical junction field effect transistor (JFET) with a gate structure formed by a vertical coupling capacitance of the embodiment of the present disclosure and the conventional JFET device is as follows:
The vertical junction field effect transistor (JFET) with a gate structure formed by a vertical coupling capacitance of the embodiment of the present disclosure indirectly controls the top gate by the capacitive coupling principle, avoiding the injection current from the top gate into the channel, and a higher voltage can be applied to the coupling capacitance upper electrode to control the channel and can be applied to more application scenarios.

The main difference between the vertical junction field effect transistor (JFET) with a gate structure formed by a vertical coupling capacitance of the embodiment of the present disclosure and the JFET device is as follows:

The vertical junction field effect transistor (JFET) with a gate structure formed by a vertical coupling capacitance of the embodiment of the present disclosure controls the electric potential of the floating top gate 8 by the coupling capacitance upper electrode 10 spaced with the dielectric layer 9 vie the capacitive coupling principle, and indirectly controls on and off of the portion of the base between the top gate 8 and the bottom gate 3, and the portion of the base between the bottom gates 3.

The top gate of the conventional JFET device is directly connected to the electrode, in a case where a high voltage is applied, the PN junction formed between the top gate and the channel is conducted, and current flows from the top gate into the channel causing negative effects. The vertical junction field effect transistor (JFET) with a gate structure formed by a vertical coupling capacitance of the embodiments of the present disclosure has an insulate dielectric layer structure, which can avoid the problem.

Specifically, the upper surface of the top gate 8 is even with the upper surface of the base.

In the embodiment, the vertical junction field effect transistor (JFET) with a gate structure formed by a vertical coupling capacitance further comprises:
a drain electrode 13, disposed on a lower surface of the base;
two source regions 7 of the first doping type, disposed on the two bottom gates 3 respectively, where the two source regions 7 are connected to the portion of the base between the top gate 8 and the bottom gate 3; and
two source electrodes 12, where each source electrode 12 is connected to the source region 7 on the same side.

Thus, the internal conducting paths inside the base from the drain electrode to the two source electrodes are formed by the base of the first doping type, the portion of the base below the gate electrode structure between the bottom gates 3, and the portion of the base below the gate electrode structure and between the top gate 8 and the bottom gate 3.

The main structure of the semiconductor device (the bottom gate 3, the second doping type ohmic contact region 4, the top gate 8 and the source region 7 are the portions of the semiconductor device) is manufactured on the upper portion of the base of the first doping type. Inside the base and above the interval between the two bottom gates 3, the top gate 8, the portion of the base between the top gate 8 and the bottom gate 3 is disposed in order from top to bottom, ensuring the portion of the base between the top gate 8 and the bottom gate 3, and the portion of the base between the bottom gates 3 are inside the base. It is ensured that the lower portion of the base of the first doping type, the portion of the base between the bottom gates 3, the portion of the base between the top gate 8 and the bottom gate 3, and the two source regions 7 are the first doping type, thus internal conducting paths inside the base from the drain electrode 13 to the two source regions 12 are formed by the lower portion of the base of the first doping type, the portion of the base below the gate electrode structure between the bottom gates 3, the portion of the base below the gate electrode structure and between the top gate 8 and the bottom gate 3, and all the internal conducting paths are away from the region with low surface mobility of the device. The overall internal conducting paths are located inside the field effect transistor of the vertical junction field effect transistor (JFET) with a gate structure formed by a vertical coupling capacitance of the embodiment of the present disclosure, and the internal conducting paths are all away from the region with low surface mobility of the device. That is, all the internal conducting paths are away from the surface of the semiconductor material, to be as body conduction, avoiding the problem of low surface mobility. The carriers are kept in a state of high mobility and drift velocity. The saturation current Idsat of the vertical junction field effect transistor (JFET) with a gate structure formed by a vertical coupling capacitance is relatively large, the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

In the SiC VDMOS device according to patent No. CN116598356A, one part of the conducting channel is disposed inside the device in the vertical direction, and the other part of the conducting channel is along the surface of the device. The charges, defects, and surface scattering at the interface of the SiC material and the oxide layer result in a low saturation current Idsat of the device and a high conducting resistance Rsp, affecting the device performance and limiting the output power and switch speed of the device. That is, the vertical junction field effect transistor (JFET) with a gate structure formed by a vertical coupling capacitance of the embodiment of the present disclosure solves the technical problem in that the conducting channel near the surface of the material with low mobility causes poor performance of the device.

The essential difference between the vertical junction field effect transistor (JFET) with a gate structure formed by a vertical coupling capacitance of the embodiment of the present disclosure and the conventional SiC VDMOS device is as follows:
the conducting paths of the vertical junction field effect transistor (JFET) with a gate structure formed by a vertical coupling capacitance of the embodiment of the present disclosure are all internal conducting paths. The internal conducting paths are all away from the surface of the semiconductor material, and as a body conduction, avoiding the problem of low surface mobility and having a better performance. The quality requirements for the gate dielectric layer of the device are low, and the reliability of the device is better.

In the embodiment, the vertical junction field effect transistor (JFET) with a gate structure formed by a vertical coupling capacitance further comprises:
two second doping type ohmic contact regions 4, disposed on the two sides of the two bottom gates 3 respectively, where each second doping type ohmic contact region 4 and the bottom gate 3 on the same side are connected.

The source electrode 12 is located on the interface of the source region 7 and the second doping type ohmic contact region 4 on the same side. That is, the source electrode 12 is connected to the source region 7 and the second doping type ohmic contact region 4 on the same side.

The bottom gate 3 is connected to the second doping type ohmic contact region 4, the second doping type ohmic contact region 4 is connected to the source electrode 12, and the bottom gate 3 is led out.

In the embodiment, as shown in Fig. 3-5, the vertical junction field effect transistor (JFET) with a gate structure formed by a vertical coupling capacitance further comprises:
a metal silicide layer 14, formed between the top gate 8 and the dielectric layer 9.

Adding the metal silicide layer (referred to as silicide layer) under the gate electrode dielectric layer, that is, the metal silicide layer 14 can be between the dielectric layer 9 and the top gate 8. Thus, the metal silicide layer 14 under the dielectric layer 9 is a metal layer, and the electric field is uniformly distributed inside the metal layer, optimizing the electric field of the top gate 8 and improving the reliability of the device.

As shown in Fig. 3-1, in the embodiment, the base comprises:
a substrate 1 of the first doping type, the drain electrode 13 being disposed on a lower surface of the substrate 1; and
an epitaxial layer 2 of the first doping type, the bottom gate 3, the top gate 8, the source region 7, and the second doping type ohmic contact region 4 being formed inside the epitaxial layer 2.

Specifically, the substrate 1 of the first doping type is heavy-doped with a high doping concentration and serves as the drain region of the vertical junction field effect transistor (JFET) with a gate structure formed by a vertical coupling capacitance.

In the embodiment, the substrate is a silicon carbide substrate.

In the embodiment, the substrate is a semiconductor device substrate such as silicon substrate, diamond substrate, or potassium oxide substrate.

The dielectric layer with the diamond substrate in the conventional MOSFET has a problem: the dielectric layer, such as the oxide layer, formed on the diamond substrate by depositing is of poor quality, resulting in poor performance. The problem can be solved by the structure of the diamond vertical capacitive coupling gate-controlled junction field effect transistor with the conducting channel disposed inside the device. Metal-oxide-semiconductor field effect transistor (MOSFET) is a common semiconductor device.

Potassium oxide, as the fourth-generation semiconductor material, can be made into electron components and electron devices, especially novel controllable semiconductor devices.

In the embodiment, the doping concentration of the top gate 8 is larger than or equal to 1×10¹⁶cm⁻³.

The doping concentration of the top gate 8 is larger than or equal to 1×10¹⁶cm⁻³ ensures in a case where a gate electrode voltage is applied, the top gate 8 is not in a depleted state and the top gate 8 has no strong electric field inside.

In the embodiment, a doping concentration of the channel I 5 is larger than a doping concentration of the base.

A doping concentration of the channel II 6 is larger than a doping concentration of the base.

The doping concentration of the channel I 5 and the doping concentration of the channel II 6 are larger than the doping concentration of the base, facilitating to reduction of the conducting resistance of the device, and improving the device performance.

Specifically, the material of the dielectric layer 9 can be selected from silicon dioxide or high-k dielectric, and it is more conducive with high-k dielectric to control the P+ type top gate by the coupling capacitance upper electrode and improving the performance of the device.

Specifically, the coupling capacitance upper electrode 10 can be selected from P+ type and N+ type heavily doped polycrystalline silicon, reducing the metal contact resistance and the parasitic resistance of the gate electrode metal, and improving the device performance.

The high-k dielectric is a material with a high dielectric constant (high relative dielectric constant).

### Embodiment 2

The second implementation of the vertical junction field effect transistor (JFET) with a gate structure formed by a vertical coupling capacitance according to the present disclosure, as shown in Fig. 3-2. The vertical junction field effect transistor (JFET) with a gate structure formed by a vertical coupling capacitance with the second implementation and the vertical junction field effect transistor (JFET) with a gate structure formed by a vertical coupling capacitance with the first implementation are partially same in structure. The difference between the vertical junction field effect transistor (JFET) with a gate structure formed by a vertical coupling capacitance with the second implementation and the vertical junction field effect transistor (JFET) with a gate structure formed by a vertical coupling capacitance with the first implementation, as shown in Fig. 3-2 is the channel I 5 of the first doping type being formed inside the base and between the top gate 8 and the bottom gate 3.

Correspondingly, the top gate 8 is disposed on the channel I 5.

As shown in Fig. 3-2, a JFET region I is formed by the top gate 8 of the second doping type, the channel I 5 of the first doping type, and the bottom gate 3; and
a JFET region II is still formed by the two bottom gates 3 and a portion between the two bottom gates 3.

The top gate 8 of the JFET region I is indirectly controlled by the coupling capacitance upper electrode 10 spaced with the dielectric layer 9. The channel I 5 of the first doping type and the portion of the base between the bottom gates 3 serve as the channel region.

The channel I 5 of the first doping type is formed by the portion between the top gate 8 and the bottom gate 3, The portion between the bottom gates 3 remains the base, which is a portion of the base between the bottom gates 3.

As shown in Fig. 3-2, the internal conducting paths inside the base from the drain electrode to the two source electrodes are formed by the base of the first doping type, the portion of the base below the gate electrode structure between the bottom gates 3, the channel I 5 of the first doping type below the gate electrode structure. The internal conducting paths are all away from the region with low surface mobility of the device.

The internal conducting paths inside the base from the drain electrode to the two source electrodes are formed by the low portion of the base of the first doping type, the portion of the base below the gate electrode structure between the bottom gates 3, the channel I 5 of the first doping type below the gate electrode structure. By controlling the internal conducting paths, the on and off of the whole vertical junction field effect transistor (JFET) with a gate structure formed by a vertical coupling capacitance can be controlled. And the controlling of the internal conducting paths is controlled by the channel I 5.

The internal conducting paths of the vertical junction field effect transistor (JFET) with a gate structure formed by a vertical coupling capacitance of the embodiment of the present disclosure are located overall inside the vertical junction field effect transistor (JFET) with a gate structure formed by a vertical coupling capacitance, and the internal conducting paths are all away from the region with low surface mobility of the device. That is, all the internal conducting paths are away from the surface of the semiconductor material and as body conduction, avoiding the problem of low surface mobility. The carriers are kept in a state of high mobility and drift velocity. The saturation current Idsat of the vertical junction field effect transistor (JFET) with a gate structure formed by a vertical coupling capacitance is relatively large, the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

As shown in Fig. 3-2, the base further comprises:
a substrate 1 of the first doping type, a drain electrode 13 being disposed on a lower surface of the substrate 1; and
an epitaxial layer 2 of the first doping type, where the bottom gate 3, the channel I 5, the top gate 8, the source region 7, and the second doping type ohmic contact region 4 are formed inside the epitaxial layer 2.

Specifically, the substrate 1 of the first doping type is heavy-doped with a high doping concentration and serves as the drain region of the vertical junction field effect transistor (JFET) with a gate structure formed by a vertical coupling capacitance.

Specifically, the channel I 5 can be formed by the ion implantation process or other processes by the original base, so that a doping concentration of the channel I 5 higher than a doping concentration of the epitaxial layer 2.

Specifically, since the doping concentration of the channel I 5 of the first doping type is higher than the doping concentration of the epitaxial layer 2, the resistance of the channel I 5 is relatively small, and further the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

### Embodiment 3

The third implementation of the vertical junction field effect transistor (JFET) with a gate structure formed by a vertical coupling capacitance according to the present disclosure is shown in Fig. 3-3. The vertical junction field effect transistor (JFET) with a gate structure formed by a vertical coupling capacitance with the third implementation and the vertical junction field effect transistor (JFET) with a gate structure formed by a vertical coupling capacitance with the first implementation are partially identical in structure. The difference between the vertical junction field effect transistor (JFET) with a gate structure formed by a vertical coupling capacitance with the third implementation and the vertical junction field effect transistor (JFET) with a gate structure formed by a vertical coupling capacitance with the first implementation, as shown in Fig. 3-3 is that a channel II 6 of the first doping type is formed inside the base by ion implantation. Correspondingly:
As shown in Fig 3-3, a JFET region I is formed by the top gate 8 of the second doping type, a portion of the base between the top gate 8 and the bottom gate 3, and the bottom gate 3 of the second doping type.

A JFET region II is formed by the two bottom gates 3 and the channel II 6.

The top gate 8 of the JFET region I is indirectly controlled by the coupling capacitance upper electrode 10 spaced with the dielectric layer 9. The portion of the base between the top gate 8 and the bottom gate 3 and the channel II 6 of the first doping type serves as the channel region.

The portion between the top gate 8 and the bottom gate 3 remains the base, which is a portion of the base between the top gate 8 and the bottom gate 3. The channel II 6 of the first doping type is formed by the portion between the bottom gates 3.

As shown in Fig. 3-3, the internal conducting paths inside the base from the drain electrode to the two source electrodes are formed by the base of the first doping type, the channel II 6 of the first doping type below the gate electrode structure, and the portion of the base below the gate electrode structure between the top gate 8 and the bottom gate 3. The internal conducting paths are all away from the region with low surface mobility of the device. The internal conducting paths of the vertical junction field effect transistor (JFET) with a gate structure formed by a vertical coupling capacitance of the embodiment of the present disclosure are located overall inside the vertical junction field effect transistor (JFET) with a gate structure formed by a vertical coupling capacitance, and the internal conducting paths are all away from the region with low surface mobility of the device. That is, all the internal conducting paths are away from the surface of the semiconductor material and as body conduction, avoiding the problem of low surface mobility. The carriers are kept in a state of high mobility and drift velocity. The saturation current Idsat of the vertical junction field effect transistor (JFET) with a gate structure formed by a vertical coupling capacitance is relatively large, the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

As shown in Fig. 3-3, the base further comprises:
a substrate 1 of the first doping type, the drain electrode 13 being disposed on a lower surface of the substrate 1; and
an epitaxial layer 2 of the first doping type, where the bottom gate 3, the channel II 6, the top gate 8, the source region 7, and the second doping type ohmic contact region 4 are formed inside the epitaxial layer 2.

Specifically, the substrate 1 of the first doping type is heavy-doped with a high doping concentration and serves as the drain region of the vertical junction field effect transistor (JFET) with a gate structure formed by a vertical coupling capacitance.

Specifically, the channel II 6 is formed by ion implantation, so that a doping concentration of the channel II 6 higher than a doping concentration of the epitaxial layer 2.

Specifically, the doping concentration of the channel II 6 of the first doping type higher than the doping concentration of the epitaxial layer 2, so that the resistance of the channel II 6 is relatively small, and further the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

### Embodiment 4

The fourth implementation of the vertical junction field effect transistor (JFET) with a gate structure formed by a vertical coupling capacitance according to the present disclosure, as shown in Fig. 3-4. The vertical junction field effect transistor (JFET) with a gate structure formed by a vertical coupling capacitance with the fourth implementation and the vertical junction field effect transistor (JFET) with a gate structure formed by a vertical coupling capacitance with the second implementation are partially identical in structure. The difference between the vertical junction field effect transistor (JFET) with a gate structure formed by a vertical coupling capacitance with the fourth implementation and the vertical junction field effect transistor (JFET) with a gate structure formed by a vertical coupling capacitance with the second implementation, as shown in Fig. 3-4, the channel II 6 of the first doping type inside the base and between the two bottom gates 3 is formed by ion implantation. Correspondingly:
As shown in Fig. 3-4, a JFET region I is formed by the top gate 8 of the second doping type, the channel I 5 of the first doping type, and the bottom gate 3 of the second doping type.

A JFET region II is formed by the two bottom gates 3 and the channel II 6.

The top gate 8 of the JFET region I is indirectly controlled by the coupling capacitance upper electrode 10 spaced with the dielectric layer 9.

The channel I 5 of the first doping type and the channel II 6 of the first doping type serve as the channel region.

The channel I 5 of the first doping type is formed by the portion between the top gate 8 and the bottom gate 3, and the channel II 6 of the first doping type is formed by the portion between the bottom gates 3.

As shown in Fig. 3-4, the internal conducting paths inside the base from the drain electrode 13 to the two source electrodes 12 are formed by the base of the first doping type, the channel II 6 of the first doping type, and the channel I 5 of the first doping type. The internal conducting paths are all away from the region with low surface mobility of the device.

Specifically, the base of the first doping type, the channel II 6 of the first doping type, and the channel I 5 of the first doping type are sequentially connected. The current transported from the drain electrode 13 flows through the base of the first doping type and the channel II 6 of the first doping type, flows at the channel I 5 of the first doping type, to the two source regions 7 on the left side and right side, and finally collected by the two source regions 12 on the left side and right side.

The internal conducting paths inside the base from the drain electrode 13 to the two source electrodes 12 are formed by the lower portion of the base of the first doping type, the channel II 6 of the first doping type, and the channel I 5 of the first doping type. By controlling the internal conducting paths, the on and off of the whole vertical junction field effect transistor (JFET) with a gate structure formed by a vertical coupling capacitance can be controlled. And the controlling of the internal conducting paths is controlled by the channel I 5.

The internal conducting paths of the vertical junction field effect transistor (JFET) with a gate structure formed by a vertical coupling capacitance of the embodiment of the present disclosure are located overall inside the vertical junction field effect transistor (JFET) with a gate structure formed by a vertical coupling capacitance, and the internal conducting paths are all away from the region with low surface mobility of the device. That is, all the internal conducting paths are away from the surface of the semiconductor material and as body conduction, avoiding the problem of low surface mobility, the carriers are kept in a state of high mobility and drift velocity. The saturation current Idsat of the vertical junction field effect transistor (JFET) with a gate structure formed by a vertical coupling capacitance is relatively large, the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

As shown in Fig. 3-4, the base further comprises:
a substrate 1 of the first doping type, the drain electrode 13 being disposed on a lower surface of the substrate; and
an epitaxial layer 2 of the first doping type, where the bottom gate 3, the channel II 6, the channel I 5, the top gate 8, the source region 7, and the second doping type ohmic contact region 4 are formed inside the epitaxial layer 2.

Specifically, the substrate 1 of the first doping type is heavy-doped with a high doping concentration and serves as the drain region of the vertical junction field effect transistor (JFET) with a gate structure formed by a vertical coupling capacitance.

Specifically, the doping concentration of the channel I 5 of the first doping type and the doping concentration of the channel II 6 of the first doping type are higher than the doping concentration of the epitaxial layer 2, so that the resistance of the channel I 5 and the resistance of the channel II 6 are relatively small, and further, the conducting resistance Rsp of the vertical junction field effect transistor (JFET) with a gate structure formed by a vertical coupling capacitance is relatively small, and the performance of the vertical junction field effect transistor (JFET) with a gate structure formed by a vertical coupling capacitance is relatively good.

It should be noted that the vertical junction field effect transistor (JFET) with a gate structure formed by a vertical coupling capacitance according to Embodiments 1 to 4 can be realized as a normally-off device and a normally-on device.

The method of realizing the vertical junction field effect transistor (JFET) with a gate structure formed by a vertical coupling capacitance according to Embodiments 1 to 4 as a normally-off device is as follows:
By controlling the doping of the bottom gate 3 of the second doping type, the channel I 5 of the first doping type, the channel II 6 of the first doping type, and the top gate 8 of the second doping type, in the case where the voltage applied to the coupling capacitance upper electrode 10 is 0V, the channel I 5 between the bottom gate 3 and the top gate 8 is in a depleted state and the vertical junction field effect transistor (JFET) with a gate structure formed by a vertical coupling capacitance is a normally-on device. The doping position and doping concentration of the bottom gate 3 and the doping concentration and doping position of the top gate 8 are mainly adjusted, and the doping concentration and doping position of the channel I 5 of the first doping type and the doping concentration and doping position of the channel II 6 of the first doping type are auxiliary adjusted.

The vertical junction field effect transistor (JFET) with a gate structure formed by a vertical coupling capacitance can also be realized as a normally-off device by adjusting the doping position and the doping concentration of the bottom gate 3 and the top gate 8 in the absence of one or both of the channel I 5 of the first doping type and the channel II 6 of the first doping type.

The method of realizing the vertical junction field effect transistor (JFET) with a gate structure formed by a vertical coupling capacitance as a normally-off device is as follows:
In a case where the first doping type is N-type doping and the second doping type is P-type doping:
in a case where no voltage is applied to the vertical capacitive coupling gate-controlled junction field effect transistor, the vertical coupling capacitance gate-controlled junction gate field effect transistor is turned off; and
in a case where a positive voltage is applied to the vertical junction field effect transistor (JFET) with a gate structure formed by a vertical coupling capacitance, the vertical coupling capacitance gate-controlled junction gate field effect transistor is conducted.

In a case where the first doping type is P-type doping and the second doping type is N-type doping:
in a case where no voltage is applied to the vertical capacitive coupling gate-controlled junction field effect transistor, the vertical coupling capacitance gate-controlled junction gate field effect transistor is turned off; and
in a case where a negative voltage is applied to the vertical junction field effect transistor (JFET) with a gate structure formed by a vertical coupling capacitance, the vertical coupling capacitance gate-controlled junction gate field effect transistor is conducted.

The method of realizing the vertical coupling capacitance gate-controlled junction gate field effect transistor as a normally-on device is as follows:
By controlling the doping of the bottom gate 3 of the second doping type, the channel I 5 of the first doping type, the channel II 6 of the first doping type, and the top gate 8 of the second doping type, in the case where the voltage applied to the coupling capacitance upper electrode 10 is 0V, the channel I 5 between the bottom gate 3 and the top gate 8 is in a conducted state and the vertical junction field effect transistor (JFET) with a gate structure formed by a vertical coupling capacitance is a normally-on device. The doping position and doping concentration of the bottom gate 3 and the doping position and doping concentration of the top gate 8 are mainly adjusted, and the doping concentration and doping position of the channel I 5 of the first doping type and the doping concentration and doping position of the channel II 6 of the first doping type are auxiliary adjusted.

The vertical junction field effect transistor (JFET) with a gate structure formed by a vertical coupling capacitance can also be realized as a normally-on device by adjusting the doping position and the doping concentration of the bottom gate 3 and the doping position and doping concentration of the top gate 8 in the absence of one or both of the channel I 5 of the first doping type and the channel II 6 of the first doping type.

The method of realizing the vertical junction field effect transistor (JFET) with a gate structure formed by a vertical coupling capacitance as a normally-on device is as follows:
In a case where the first doping type is N-type doping and the second doping type is P-type doping:
in a case where no voltage is applied to the vertical junction field effect transistor (JFET) with a gate structure formed by a vertical coupling capacitance, the vertical coupling capacitance gate-controlled junction gate field effect transistor is conducted; and
in a case where a negative voltage is applied to the vertical junction field effect transistor (JFET) with a gate structure formed by a vertical coupling capacitance, the vertical coupling capacitance gate-controlled junction gate field effect transistor is turned off.

In a case where the first doping type is P-type doping and the second doping type is N-type doping:
in a case where no voltage is applied to the vertical junction field effect transistor (JFET) with a gate structure formed by a vertical coupling capacitance, the vertical coupling capacitance gate-controlled junction gate field effect transistor is conducted; and
in a case where a positive voltage is applied to the vertical junction field effect transistor (JFET) with a gate structure formed by a vertical coupling capacitance, the vertical coupling capacitance gate-controlled junction gate field effect transistor is turned off.

Embodiments 1 to 4 of the present disclosure provide vertical junction field effect transistor (JFET) with a gate structure formed by a vertical coupling capacitances, the threshold voltage of the device is 3.03V, the breakdown voltage is 1507V, and the conducting resistance is 0.192Ω·mm².

Embodiments 1 to 4 of the present disclosure provide vertical junction field effect transistor (JFET) with a gate structure formed by a vertical coupling capacitances, the conducting channels are all inside the device and are less affected by the interface charges and the low interface mobility of the device.

Compared with the conventional SiC VDMOS, the conducting resistance is improved by 20%. Due to the capacitive coupling effect of the channel, the current of the present disclosure is saturated at a high gate voltage, improving the short-circuit resistance capability of the device. The gate electrode of the vertical junction field effect transistor (JFET) with a gate structure formed by a vertical coupling capacitance of the present disclosure is a coupling capacitance gate, with the principle of capacitive coupling to operate and control the device. The electrode work function of the capacitance is low and the coupling capacitance dielectric can be flexibly selected. In a case where the device is broken down, the typical electric field intensity in the dielectric layer is about 2×10⁵V/cm, lower than the typical electric field intensity of the conventional silicon carbide device by about an order of magnitude. The quality of the capacitive coupling dielectric is low and has obvious advantages in high reliability, robustness, and manufacturability.

The following is an example of a case where the first doping type is N-type, and the second doping type is P-type:
In the embodiment of the present disclosure, a JEFT region is formed by the P+ type top gate 8, the N-type channel I 5, and the P-type bottom gate 3, a PN junction is formed by the P+ type top gate 8 and the N-type channel I 5, and a PN junction is formed by the P+ type bottom gate 3 and the N-type channel I 5. By controlling the voltage of the coupling capacitance upper electrode 10, the channel I 5 is depleted and pinched off, so as to realize the controlling of the conducting paths, and finally realize the controlling of the on-off of the vertical junction field effect transistor (JFET) with a gate structure formed by a vertical coupling capacitance.

In the JFET device according to patent No. CN1238904C, the gate electrode and the channel are a PN junction structure, and a voltage higher than 3V cannot be applied to the gate electrode. For the substrate based on SiC material, in a case where a voltage of 3V or more is applied to the gate electrode, the gate electrode and the channel are conducted or the gate electrode and the source electrode are conducted, and the conducting current strongly affects the current characteristic from the drain electrode to the source electrode. The gate electrode cannot be applied to a high voltage, which limits the application as a power switch.

The following is an example of a case where the first doping type is N-type, and the second doping type is P-type:
In the JFET region of the vertical junction field effect transistor (JFET) with a gate structure formed by a vertical coupling capacitance of the embodiment of the present disclosure, a depletion region is formed by the self-build electric field of the P+ type top gate 8 and the N-type channel I 5, a depletion region is formed by the self-build electric field of the P-type bottom gate 3 and the N-type channel I 5, and the depletion regions of the self-build electric field formed by two PN junctions are connected, so to realize the self-depletion and the pinch-off of the N-type channel I 5, and further realize the normally-off function of the device. That is, in a case where no voltage is applied to the coupling capacitance upper electrode 10, the drain electrode 13 and the source electrode 12 are turned off; and in a case where a voltage is applied to the coupling capacitance upper electrode 10, path between the drain electrode 13 and the source electrode 12 are turned on.

The JFET device according to patent No. CN1238904C is a normally-on device, that is, in a case where no voltage is applied to the gate electrode, the device is conducted, and a negative voltage must be applied to the gate to turn off the device, limiting the application as a power switch.

### Embodiment 5

A manufacturing method of the vertical junction field effect transistor (JFET) with a gate structure formed by a vertical coupling capacitance is provided according to the present disclosure and comprises:
forming a base of the first doping type;
forming two bottom gates 3 of the second doping type, inside the base and spaced apart in the lateral direction;
forming a top gate 8 of the second doping type inside the base, where the top gate 8 is located above the interval between the two bottom gates 3 and an interval is formed between the top gate 8 and the bottom gate 3;
forming a dielectric layer 9, on the base and located on the top gate 8;
forming a coupling capacitance upper electrode 10, on the dielectric layer 9;
forming two source regions 7 of the first doping type, on the two bottom gates 3 respectively, where the two source regions 7 are connected to the portion of the base between the top gate 8 and the bottom gate 3; and
forming two source electrodes 12, where each source electrode is connected to the source region 7 on the same.

In the embodiment, the manufacturing method further comprises:
forming a channel I 5 of the first doping type, between the top gate 8 and the bottom gate 3, where the top gate 8 is on the channel I 5.

In the embodiment, the manufacturing method further comprises:
forming a channel II 6 of the first doping type, between the two bottom gates 3 by ion implantation.

In the embodiment, the dielectric layer 9 is made of high dielectric constant material and the coupling capacitance upper electrode 10 can be a polycrystalline silicon electrode or metal electrode.

In the embodiment, the manufacturing method of the vertical junction field effect transistor (JFET) with a gate structure formed by a vertical coupling capacitance further comprises:
forming a drain electrode 13, on a lower surface of the base; and
forming two source regions 7 of the first doping type, on the two bottom gates 3 respectively, where the two source regions 7 are connected to the portion of the base between the top gate 8 and the bottom gate 3; and
forming two second doping type ohmic contact regions 4, on the two sides of the two bottom gates 3 respectively, where each second doping type ohmic contact region 4 and the bottom gate 3 on the same side are connected.

The source electrode 12 is located on the interface of the source region 7 and the second doping type ohmic contact region 4 on the same side, the source electrode 12 is connected to the source region 7 and the second doping type ohmic contact region 4 on the same side.

The following is an example of a case where the first doping type is N-type and the second doping type is P-type, a manufacturing method of the vertical junction field effect transistor (JFET) with a gate structure formed by a vertical coupling capacitance of the present disclosure is described, and comprises the following steps:
As shown in Fig. 4, a SiC N+ type substrate 1 serves as the substrate structure of the vertical junction field effect transistor (JFET) with a gate structure formed by a vertical coupling capacitance of the embodiment of the present disclosure. The low-resistance substrate structure serves as a support structure, forming an N-type epitaxial layer 2 on the substrate by epitaxy, and the epitaxial layer 2 subsequently serves as a drift region for bearing the voltage of the device and a main region for forming the device.

As shown in Fig. 5, based on the structure in Fig. 4, forming P-type bottom gates 3 and P+ type ohmic contact regions 4 by ion implantation, where the two P-type bottom gates 3 are injected at an appropriate distance from each other, and the portion between the two bottom gates 3 are injected to form the N-type channel II 6 subsequently. The device is in a middle-symmetric structure to be one whole cell, and the actual device consists of multiple same arrangements of the cell.

As shown in Fig. 6, based on the structure in Fig. 5, forming an N-type channel I 5, an N-type channel II 6, and an N+ type ohmic contact region 7, and forming conducting paths from the drain electrode 13 to the source electrode 12, that is the N+ type substrate1, the N-type epitaxial layer 2, the N-type channel II 6, the N-type channel I 5, and the N+ type ohmic contact region 7. The current is transported from the drain electrode 13 and collected by the two source electrodes 12 on the left side and the right side.

As shown in Fig. 7, based on the structure in Fig. 6, forming a P+ type top gate 8 by ion implantation. A JFETE region is formed by the P+ type top gate 8, N-type channel I 5, and the P-type bottom gate 3.

As shown in Fig. 8, based on the structure in Fig. 7, forming a dielectric layer 9 by chemical vapor deposition, and forming a coupling capacitance upper electrode 10 on the dielectric layer 9 by depositing.

As shown in Fig. 9, based on the structure in Fig. 8, forming a metal silicide of the source electrode 12 at the surface of the device by depositing, thermal reaction, and etching, to form a deposition having good ohmic contact with the device. Subsequently, after the other process of depositing the passivation layer, etching the through-hole, forming the surface metal, etc., the coupling capacitance upper electrode 10 and the source electrode 12 of the device are led to the surface, and the front side processes and structure of the device are completed.

As shown in Fig. 10, based on the structure in Fig. 9 after the front side processes of the device are completed, grinding to be thin and metabolizing the back side of the wafer, and forming the drain electrode 13 at the back side of the device, to form the complete vertical device structure.

The operating principle of the vertical junction field effect transistor (JFET) with a gate structure formed by a vertical coupling capacitance of the present disclosure is described in detail as follows:
The equivalent circuit diagram of the vertical coupling capacitance gate-controlled junction gate field effect transistor according to Embodiment 4 (corresponding to Fig. 3-4) is shown in Fig. 11 as a structure where a capacitor is connected in series with the junction field effect transistor. In the circuit diagram, the capacitor is co-coupled with the semiconductor junction capacitor of the JFET to divide the voltage and control the on-off of the JFET.

When the vertical junction field effect transistor (JFET) with a gate structure formed by a vertical coupling capacitance of the present disclosure is operating, the voltage is applied to the coupling capacitance upper electrode 10 and the drain electrode 13. The voltage applied to the coupling capacitance upper electrode 10 will be coupled to top gate 8 by the coupling capacitance upper electrode 10 and the dielectric layer 9. The electric potential coupled to the top gate 8, and the bottom gate 3 connected to the source electrode forms the region controlling the channel of the JFET device, to control the on-off of the middle channel.

The JFET region (comprising the JFET region I and the JFET region II) will be in the off state in a case where the voltage is applied to turn the channel off, the channel I 5 and the channel II 6 will be in a depleted state, and the number of the carriers in the channel in the depleted state will be low, and a voltage is applied to the drain electrode 13 at the same time, no current or a very small current passes through the drain electrode 13 to the source electrode 12, due to the channel of the device being in the depleted in the off state.

The JFET region (comprising the JFET region I and the JFET region II) will be in the conducted state in a case where the voltage is applied to turn the channel on, the channel I 5 and the channel II 6 will be in the conducted state connecting from the drain electrode to the source electrode, and a voltage is applied to the drain electrode 13 at the same time, the current passes through the drain electrode 13 to the source electrode 12 due to the channel of the device being in the conducted state, and the device works.

In the vertical junction field effect transistor (JFET) with a gate structure formed by a vertical coupling capacitance of the present disclosure, with the SiC wide band gap semiconductor characteristic, is a device for FET channel current modulation with the wide band gap semiconductor characteristic.

Three common methods of modulating the channel are provided in the related art, the first method is the conventional Si MOSFET with an inversion layer combined with high-quality silicon dioxide of thermal oxygen grown and adapted to the silicon material, which can be produced and applied on a large scaler.

The second method is the GaAs/AlGaAs and GaN/AlGaN heterojunction (FET), referred to as the HFET. The structure of the device is difficult to be enhancement-mode, and is solved by embedding the gate structure and fluorine ion implantation.

The third method is based on the JFET principle, silicon-based JFET device can only be formed into a normally-on device because the band gap of Si material is only 1.1eV.

The device of the present disclosure with the wide band gap characteristic of the SiC material, the high built-in voltage formed by the SiC wide band gap to modulate the channel current, realizing the device normally-off function (the threshold voltage is not more than 1V, the operating voltage is not more than 3V), and with the coupling capacitance gate structure, the threshold voltage can reach more than 3V, the operating voltage can reach more than 15V, which is fully matched the performance of the conventional SiC MOSFET.

The threshold voltage of the vertical capacitive coupling gate-controlled junction field effect transistor of the present disclosure can be modulated according to the doping. In the case where the JFET region self-pinch-off by the doping modulating, no voltage is applied to the gate electrode of the device, under the effect of the own doped self-build electric field, the carriers in the channel I 5 and the channel II 6 will be depleted to form a depletion region, and the device is a normally-off device. The depletion region can only disappear by applying a positive voltage to the JFET region (comprising the JFET region I and the JFET region II) to form an effective channel for conduction. Affected by the wide band gap characteristic of the silicon carbide, the inner-built potential of the PN junction formed by the silicon carbide material is large and can realize a normally-off device structure.

When the JFET region (comprising the JFET region I and the JFET region II) is not self-pinch-off, the device is a normally-on device with the formed channel. According to the operating principle of the JFET, a voltage needs to be applied to the controlling region of the JFET to make the channel form into a depletion region to make the device turn off.

The conducting resistance Rsp of the vertical capacitive coupling gate-controlled junction field effect transistor of the present disclosure is mainly determined by the resistance R1 of the JFET region I, the resistance R2 of the JFET region II, and the resistance R3 of the epitaxial layer 2, and the voltage applied to the drain electrode 13 of the device is divided by the three resistance in series. The reduction of the resistances of each region has an optimizing effect on the overall conducting resistance Rsp of the device.

The advantages of the vertical junction field effect transistor (JFET) with a gate structure formed by a vertical coupling capacitance of the present disclosure are described as follows:
The gate electrode of the vertical junction field effect transistor (JFET) with a gate structure formed by a vertical coupling capacitance of the present disclosure adopting the coupling capacitance method has the advantages over the conventional wide band gap metal-oxide-semiconductor field effect transistor:

Fig. 12 is a schematic diagram of the vertical junction field effect transistor (JFET) with a gate structure formed by a vertical coupling capacitance according to the present disclosure in a conducted state, illustrating a current path. Fig. 13 is a comparison schematic diagram of the characteristics of the vertical junction field effect transistor (JFET) with a gate structure formed by a vertical coupling capacitance according to the present disclosure with the characteristics of the conventional VDMOS device.

As shown in Fig. 12, the solid lines with arrows show the current paths in a case where the field effect transistor is in a conducted state. As shown in Fig. 12, the current paths of the vertical junction field effect transistor (JFET) with a gate structure formed by a vertical coupling capacitance of the present disclosure in a conducted state are located inside the device, away from the surface of the semiconductor material, and are not affected by the low mobility of the surface of the material. The performance of the vertical junction field effect transistor (JFET) with a gate structure formed by a vertical coupling capacitance of the present disclosure is mainly affected by the thickness of the capacitance dielectric, and the requirement of the electrode work function is low. In a case where the coupling capacitance upper electrode 10 is the polycrystalline silicon material, N-type or P-type polycrystalline silicon can play the function of capacitive coupling, and the capacitance dielectric can be flexibly selected, such as the conventional oxide material or the high-k dielectric, can also play the function of the capacitive coupling.

Fig. 13 is a comparison schematic diagram of the characteristics of the vertical junction field effect transistor (JFET) with a gate structure formed by a vertical coupling capacitance according to the present disclosure with the characteristics of the conventional VDMOS device. As shown in Fig. 13, the vertical junction field effect transistor (JFET) with a gate structure formed by a vertical coupling capacitance of the present disclosure has obvious advantages on smaller conducting resistance Rsp compared to the device with the same active region area.

Fig. 14-1 is a schematic diagram of the vertical junction field effect transistor (JFET) with a gate structure formed by a vertical coupling capacitance according to the present disclosure.

Fig. 14-2 is an internal electric field distribution diagram in the vertical direction of the vertical junction field effect transistor (JFET) with a gate structure formed by a vertical coupling capacitance according to the present disclosure in a broken down state. As shown in Fig. 14-2, the electric field intensity on the vertical axis and the vertical position on the horizontal axis.

Where the vertical dotted line in Fig. 14-1 shows the vertical direction. The portion of the vertical dotted line to the below of the horizontal dotted line in Fig. 14-2 corresponds to the portion of the horizontal axis that coordinates 0 to the right in Fig. 14-2, and the portion of the vertical dotted line to the above of the vertical dashed line in Fig. 14-1 corresponds to the portion of the horizontal axis that coordinates 0 to the left in Fig. 14-2.

As shown in Fig. 14-1, the vertical junction field effect transistor (JFET) with a gate structure formed by a vertical coupling capacitance of the present disclosure works by the capacitive coupling principle, the dielectric serves as an insulating layer. In a case where a voltage is applied to the gate electrode of the device, the electric potential is coupled to the top gate 8. Due to the top gate 8 in a physically floating structure, no current passes through the dielectric layer 9 to the top gate 8 as the main controlling region of the JFET region of the device. As shown in Fig. 12, the current conducting paths do not pass through the top gate 8 of the device, and the top gate 8 has high reliability and has no large current. As shown in Fig. 14-2, under the high drain voltage (the breakdown condition) turning the device off, the vertical epitaxial layer-JFET regions (the channel I and the channel II)-top gate-dielectric layer is the main bearing voltage region. Due to the structure of the semiconductor PN junction of the JFET region (the channel I and the channel II)-top gate, the depletion region of the top gate has a constant amount of the negative charges, and the electric field lines start from the positive charges in the epitaxial layer and ends at the negative charges in the top gate, so the high electric field will be shielded at the junction interface of the semiconductor junction. The electric field intensity in the dielectric layer is reduced by the shielding effect of the top gate. The typical dielectric electric field intensity is about 2×10⁵ V/cm (the electric field intensity in the dielectric layer at the location marked with a circle in Fig. 14-2), lowering than the electric field intensity in the dielectric layer of the conventional silicon carbide VDMOS device by an order of magnitude, and the low electric field intensity in the dielectric layer plays a key role in protecting the dielectric layer and improving reliability.

Fig. 15-1 is a schematic diagram of the vertical junction field effect transistor (JFET) with a gate structure formed by a vertical coupling capacitance according to the present disclosure.

Fig. 15-2 is a potential distribution diagram of the gate electrode structure of the vertical junction field effect transistor (JFET) with a gate structure formed by a vertical coupling capacitance according to the present disclosure. As shown in Fig. 15-2, the potential distribution on the vertical axis and the vertical position on the horizontal axis.

Where the vertical dotted line in Fig. 15-1 shows the vertical direction. The lower portion of the vertical dotted line below the horizontal dotted line in Fig. 15-1 corresponds to the right portion of the horizontal axis from coordinate 0 in Fig. 15-2, and the upper portion of the vertical dotted line above the vertical dashed line in Fig. 15-1 corresponds to the left portion of the horizontal axis from coordinate 0 in Fig. 15-2.

Due to the capacitive coupling effect of the channel, the current of the present disclosure is saturated at a high gate voltage.

The gate electrode voltage dividing principle of the device of the present disclosure is shown in Fig. 15-2, the dielectric layer capacitance C_{gate} formed by the coupling capacitance upper electrode 10, dielectric layer 9, and the top gate 8, and the junction capacitance Cₛₑₘ formed by the semiconductor depletion region formed by the top gate 8 and the channel I 5 are connected in series to divide the voltage to control the on-off of the channel. In a case where the external gate voltage is Vgs, the voltage shared across the dielectric layer capacitance C_{gate} is Vgs·Cₛₑₘ/(C_{gate}+Cₛₑₘ), the voltage shared across the semiconductor depletion region junction capacitance Cₛₑₘ is Vgs·C_{gate} /(C_{gate}+Cₛₑₘ). The dielectric layer capacitance C_{gate} is a constant value determined by the material and thickness of the dielectric layer 9. When the Vgs begins to increase from 0, the C_{gate} divides the voltage with the depletion region junction capacitance Cₛₑₘ formed by the semiconductor self-build electric field. The voltage Vgs applied to the coupling capacitance upper electrode 10 is partly coupled to the semiconductor junction capacitance, and the percentage of voltage coupled to the semiconductor depletion region junction capacitance Cₛₑₘ, i.e., the C_{gate} /(C_{gate}+Cₛₑₘ), is maximum. As the gate voltage Vgs increases and the voltage coupled to the semiconductor depletion region junction capacitance Cₛₑₘ increases, the depletion region of the semiconductor junction capacitance Cₛₑₘ will be narrowed, and the junction capacitance Cₛₑₘ will be larger, and the percentage of voltage coupled to the semiconductor depletion region junction capacitance Cₛₑₘ, i.e., the C_{gate} /(C_{gate}+Cₛₑₘ), will be gradually smaller. Until the semiconductor depletion region is narrowed to a constant point, that is, the interface immediately adjacent to the semiconductor junction can not continue to narrow, the semiconductor depletion region junction capacitance Cₛₑₘ increases to a relatively large value and remain constant, and will not continue to increase subsequently. At this time, with the voltage Vgs applied to the coupling capacitance upper electrode 10, the electric potential coupled to the top gate 8 is maximized and the device is saturated.

Figs. 16-1, 16-2, 16-3, 16-4, 16-5, and 16-6 are energy band distribution diagrams for different voltages applied to the coupling capacitance upper electrode 10 of the vertical junction field effect transistor (JFET) with a gate structure formed by a vertical coupling capacitance of the present disclosure; the potential distribution on the vertical axis and the vertical position on the horizontal axis.

Where the vertical dotted line in Fig. 15-1 shows the vertical direction. The lower portion of the vertical dotted line below the horizontal dotted line in Fig. 15-1 corresponds to the right portion of the horizontal axis from coordinate 0 in Figs. 16-1, 16-2, 16-3, 16-4, 16-5, 16-6, and the upper portion of the vertical dotted line above the vertical dotted line in Fig. 15-1 corresponds to the left portion of the horizontal axis from coordinate 0 in Figs. 16-1, 16-2, 16-3, 16-4, 16-5, 16-6.

Figs. 16-1, 16-2, 16-3, 16-4, 16-5, and 16-6 are energy band distribution diagrams for the top gate 8, channel I 5, and the bottom gate 3 of the vertical capacitive coupling gate-controlled junction field effect transistor of the present disclosure, and shows the relative changes of the conduction band, the valence band, the electrons and the holes Fermi level in each region when the gate electrode of the device works. As shown in Fig. 16-1, When the voltage Vgs applied to the coupling capacitance upper electrode 10 is 0V, as an example of the channel I 5 in the self-depleted state, the Fermi level in the channel I 5 is located in the center of the band gap, the device is in the depleted state, and the electron concentration and the hole concentration in the channel I 5 are both extremely low. The Fermi levels in the top gate 8 and the bottom gate 3 are located near the valence band, the hole concentration is extremely high and the electron concentration is extremely low. As the voltage Vgs applied to the coupling capacitance upper electrode 10 increases, the distance between the conduction band and the electron Fermi level in the top gate 8 and the channel I 5 gradually decreases, a low concentration of electrons appears in the top gate 8, the distance between the conduction band and the electron Fermi level in the channel I 5 is closer, and an extremely high electron concentration in the channel I 5 can be involved in the conductivity to form a conductive channel. Meanwhile, the distance between the valence band and the hole Fermi level in the channel 5 gradually decreases, and a low hole concentration appears in the channel I 5.

Fig. 17-1 is a carrier concentration distribution diagram in each region of the vertical junction field effect transistor (JFET) with a gate structure formed by a vertical coupling capacitance of the present disclosure when working, illustrating the hole concentration in the top gate 8, the channel I 5, and the bottom gate 3 affected by the voltage applied to the coupling capacitance upper electrode 10. The hole concentration on the vertical axis and the vertical direction on the horizontal axis. Fig. 17-2 is a carrier concentration distribution diagram in each region of the vertical junction field effect transistor (JFET) with a gate structure formed by a vertical coupling capacitance according to the present disclosure when working, illustrating the electron concentration in the top gate 8, the channel I 5, and the bottom gate 3 affected by the voltage applied to the coupling capacitance upper electrode 10. The electron concentration on the vertical axis and the vertical direction on the horizontal axis. In a case where the voltage Vgs applied to the coupling capacitance upper electrode 10is 0V, the hole concentration in the top gate 8 is extremely high and the electron concentration is extremely low. When the channel I 5 is modulated from doping to a self-depleted state, the electron concentration and the hole concentration are very low. As the voltage Vgs applied to the coupling capacitance upper electrode 10increases, the voltages coupled to the dielectric layer 9 capacitance and the semiconductor junction capacitance formed by the top gate 8 and the channel I 5 increase due to the capacitive coupling principle. As the voltage applied to the semiconductor junction formed by the top gate 8 and the channel I 5 increases, the depletion region in the channel I 5 narrows and changes from the depleted state to the undepleted state, and the electron concentration in the channel I 5 increases dramatically to form a conductive channel. Meanwhile, the inner-built potential of the semiconductor junction formed by the top gate 8 and the channel I 5 decreases, part of the electrons in the channel I 5 enter into the top gate 8, the electron concentration in the top gate 8 changes from extremely low to appear a low electron concentration, and part of the holes in the top gate 8 enter into the channel I 5, the hole concentration in the semiconductor junction formed by the top gate 8 and the channel I 5 increases.

Fig. 18-1 is a transfer characteristic curve graph of the vertical junction field effect transistor (JFET) with a gate structure formed by a vertical coupling capacitance according to the present disclosure. As shown in Fig. 18-1, the transfer characteristic curve of the vertical junction field effect transistor (JFET) with a gate structure formed by a vertical coupling capacitance of the present disclosure, by the transfer characteristic principle, voltages are applied to the gate electrode and the drain electrode at the same time, the gate electrode voltage on the horizontal axis and the drain electrode current on the vertical axis. In the case where a low voltage is applied to the gate electrode, the device turns off and the current is low. As the gate electrode voltage increases and the drain electrode current increases. In a case where the gate electrode voltage increases to a relatively large value, the semiconductor junction capacitance remains constant and the device is saturated. Fig. 18-2 is a transfer characteristic curve graph of a conventional SiC MOSFET device; the drain electrode current on the vertical axis and the gate electrode on the horizontal axis. The conventional SiC MOSFET device still does not show current saturation characteristics at Vgs 20V, and the current conducting paths of the device of the present disclosure are away from the surface of the dielectric, improving the short-circuit resistance of the device. As shown in Fig. 18-1, the gate electrode voltage is essentially smoother after 6V. As shown in Fig. 18-2, the gate voltage remains at a rapid rise even after 15V. Thus, the stability of the vertical junction field effect transistor (JFET) with a gate structure formed by a vertical coupling capacitance of the present disclosure is relatively good.

The vertical capacitive coupling gate-controlled junction field effect transistor of the present disclosure has obvious advantages in high reliability, robustness, and manufacturability.

In the descriptions of the disclosure and the embodiments thereof, it is to be understood that orientation or position relationships indicated by terms "top", "bottom", "height", and the like are orientation or position relationships shown in the drawings, are adopted not to indicate or imply that indicated devices or components must be in specific orientations or structured and operated in specific orientations but only to conveniently describe the disclosure and simplify descriptions, and thus should not be understood as limits to the disclosure.

In the disclosure and the embodiments thereof, unless otherwise definitely specified and limited, terms "arrange", "mount", "mutually connect", "connect", "fix" and the like should be broadly understood. For example, the terms may refer to fixed connection and may also refer to detachable connection or integration. The terms may refer to mechanical connection, may also refer to electrical connection, and may also refer to communication. The terms may refer to direct mutual connection, may also refer to indirect connection through a medium, and may refer to communication in two components or an interaction relationship of the two components. Those having ordinary skills in the art may understand specific meanings of the above terms in the embodiments of the present disclosure according to specific situations.

In the disclosure and the embodiments thereof, unless otherwise expressly stated and defined, the state that a first feature is "above" or "below" a second feature may include that the first feature directly contacts with the second feature, or may include that the first and second features contact not directly but through another feature therebetween. Moreover, the state that the first feature is "above", "over" and "on" the second feature may include that the first feature is over and above the second feature, or only represents that a horizontal height of the first feature is greater than that of the second feature. The state that the first feature is "below", "under" and "beneath" the second feature may include that the first feature is under and below the second feature, or only represents that the horizontal height of the first feature is less than that of the second feature.

The above disclosure provides many different implementation modes or examples to implement different structures of the disclosure. To simplify the disclosure components and arrangements in specific examples are described above. Of course, they are merely examples and not intended to limit the disclosure. In addition, reference numbers and/or reference letters in the disclosure can be repeated in different examples, and such repetitions are for purposes of simplicity and clarity, and do not indicate relationships between the discussed implementation modes and/or arrangements. Moreover, the disclosure provides examples of various specific processes and materials, but those of ordinary skill in the art can realize disclosures of other processes and/or uses of other materials.

Although some optional embodiments of the disclosure have been described, those skilled in the art, once learning about basic creative concepts, may make other variations and modifications to these embodiments. Therefore, the invention is solely defined by the appended set of claims.

## Claims

1. A vertical junction field effect transistor with a gate structure formed by a vertical coupling capacitance, comprising:
a base of a first doping type;
two bottom gates (3) of a second doping type, formed inside the base and spaced apart in a lateral direction;
a top gate (8) of the second doping type, formed inside the base, wherein the top gate (8) is located above an interval between the two bottom gates (3), and an interval is formed in the vertical direction between the top gate (8) and the bottom gates (3);
two source regions (7) of the first doping type, disposed on the two bottom gates (3) respectively, wherein the two source regions (7) are connected to a portion of the base between the top gate (8) and the bottom gates (3);
two source electrodes (12), wherein each source electrode (12) is connected to a repective source region (7);
a substrate (1) of the first doping type, wherein a drain electrode (13) is disposed on a lower surface of the substrate (1); and
two second doping type ohmic contact regions (4), each disposed on and connected to a side of one of the respective bottom gates (3);
wherein each source electrode (12) is located on an interface of a source region (7) and a second doping type ohmic contact region (4), and each source electrode (12) is connected to a source region (7) and a second doping type ohmic contact region (4);
wherein each bottom gate (3) is connected to a second doping type ohmic contact region (4), each second doping type ohmic contact region (4) is connected to a source electrode (12);
**characterized in that**, a dielectric layer (9), is disposed on the base and located on the top gate (8) and an electrode (10) is disposed on the dielectric layer;
wherein a coupling capacitance is formed by the electrode (10), the dielectric layer (9), and the top gate (8); the top gate (8) is floating and indirectly controlled by the electrode (10) spaced with the dielectric layer (9), and a gate electrode structure is formed by the electrode (10), the dielectric layer (9), and the top gate (8) as a whole.

2. The vertical junction field effect transistor according to claim 1, further comprising:
a first channel (5) of the first doping type, formed between the top gate (8) and the bottom gates (3), wherein the top gate (8) is located on the first channel (5);
wherein a first JFET region is formed by the top gate (8) of the second doping type, the first channel (5) of the first doping type, and the bottom gates (3).

3. The vertical junction field effect transistor according to claim 1, further comprising:
a second channel (6) of the first doping type, formed between the two bottom gates (3);
wherein the first JFET region is formed by the top gate (8) of the second doping type, a portion of the base between the top gate (8) and the bottom gates gate(3), and the bottom gates (3); and
a second JFET region is formed by the two bottom gates (3) and the second channel (6).

4. The vertical junction field effect transistor according to any one of claims 1 to 3, wherein internal conducting paths inside the base from the drain electrode (13) to the two source electrodes (12) are formed by the base of the first doping type, a portion below the gate electrode structure between the bottom gates (3 and a portion below the gate electrode structure and between the top gate (8) and the bottom gates (3).

5. The vertical junction field effect transistor according to any one of claims 1 to 4, wherein the vertical junction field effect transistor is a normally-off device or a normally-on device.

6. The vertical junction field effect transistor according to claims 1 to 5, wherein the substrate (1) is selected from one of silicon carbide substrate, silicon substrate, diamond substrate, or potassium oxide substrate;
the dielectric layer (9) is made of high dielectric constant material; and
the electrode (10) is selected from one of polycrystalline silicon electrode or metal electrode.

7. The vertical junction field effect transistor according to any one of claims 1 to 6, further comprising:
a metal silicide layer (14), formed between the top gate (8) and the dielectric layer (9).

8. The vertical junction field effect transistor according to any one of claims 1 to 7, wherein a doping concentration of the top gate (8) is larger than or equal to 1×10¹⁶cm⁻³.

9. The vertical junction field effect transistor according to claim 3, wherein a doping concentration of the first channel 5) is larger than a doping concentration of the base; and
a doping concentration of the second channel (6) is larger than a doping concentration of the base.

10. A manufacturing method of the vertical junction field effect transistor with a gate structure formed by a vertical coupling capacitance, comprising:
forming a base of a first doping type;
forming two bottom gates (3) of a second doping type, inside the base and spaced apart in a lateral direction;
forming a top gate (8) of the second doping type, inside the base, wherein the top gate (8) is located above an interval between the two bottom gates (3), and an interval is formed in the vertical direction between the top gate (8) and the bottom gates (3);
forming two source regions (7) of the first doping type, on the two bottom gates (3) respectively, wherein the two source regions (7) are connected to a portion of the base between the top gate (8) and the bottom gates (3);
forming two source electrodes (12), wherein each source electrode (12) is connected to a respective source region (7);
forming a substrate (1) of the first doping type, wherein a drain electrode (13) is disposed on a lower surface of the substrate (1); and
forming two second doping type ohmic contact regions each disposed on and connected to a side of one of the respective bottom gates (3);
wherein each source electrode (12) is located on an interface of a source region (7) and a second doping type ohmic contact region (4), and each source electrode (12) is connected to a source region (7) and a second doping type ohmic contact region (4);
wherein each bottom gate (3) is connected to a second doping type ohmic contact region (4), each second doping type ohmic contact region (4) is connected to a source electrode (12);
**characterized in** forming a dielectric layer (9), located on the base and on the top gate (8) and forming an electrode (10) on the dielectric layer (9); wherein a coupling capacitance is formed by the electrode (10), the dielectric layer (9), and the top gate (8); the top gate (8) is floating and indirectly controlled by the electrode (10) spaced with the dielectric layer (9) and a gate electrode structure is formed by the electrode (10), the dielectric layer (9) and the top gate (8) as a whole.

11. The manufacturing method according to claim 10, further comprising:
forming a first channel (5) of the first doping type, between the top gate (8) and the bottom gates (3), wherein the top gate (8) is located on the first channel (5)

12. The manufacturing method according to claim 11, further comprising:
forming a second channel (6) of the first doping type, between the two bottom gates (3) by ion implantation.

13. The manufacturing method according to any one of claims 10 to 12, wherein the dielectric layer (9) is a high dielectric constant material dielectric layer; and
the electrode (10) is selected from one of a polycrystalline silicon electrode or metal electrode.

## Patentansprüche

1. Vertikaler Sperrschicht-Feldeffekttransistor mit einer durch vertikale Kopplungskapazität ausgebildeten Gate-Struktur, umfassend:
eine Basis eines ersten Dotierungstyps;
zwei untere Gates (3) eines zweiten Dotierungstyps, die in der Basis ausgebildet und in seitlicher Richtung beabstandet sind;
ein oberes Gate (8) des zweiten Dotierungstyps, das in der Basis ausgebildet ist, wobei sich das obere Gate (8) oberhalb eines Zwischenraums zwischen den zwei unteren Gates (3) befindet und in vertikaler Richtung ein Zwischenraum zwischen dem oberen Gate (8) und den unteren Gates (3) ausgebildet ist;
zwei Source-Regionen (7) des ersten Dotierungstyps, die jeweils an einem der zwei unteren Gates (3) angeordnet sind, wobei die zwei Source-Regionen (7) mit einem Abschnitt der Basis zwischen dem oberen Gate (8) und den unteren Gates (3) verbunden sind;
zwei Source-Elektroden (12), wobei jede Source-Elektrode (12) mit einer jeweiligen Source-Region (7) verbunden ist;
ein Substrat (1) des ersten Dotierungstyps, wobei eine Drain-Elektrode (13) an einer unteren Oberfläche des Substrats (1) angeordnet ist; und
zwei ohmsche Kontaktregionen (4) des zweiten Dotierungstyps, die jeweils an einer Seite von einem der jeweiligen unteren Gates (3) angeordnet und damit verbunden sind;
wobei sich jede Source-Elektrode (12) an einer Grenzfläche einer Source-Region (7) und einer ohmschen Kontaktregion (4) des zweiten Dotierungstyps befindet und jede Source-Elektrode (12) mit einer Source-Region (7) und einer ohmschen Kontaktregion (4) des zweiten Dotierungstyps verbunden ist;
wobei jedes untere Gate (3) mit einer ohmschen Kontaktregion (4) des zweiten Dotierungstyps verbunden ist, jede ohmsche Kontaktregion (4) des zweiten Dotierungstyps mit einer Source-Elektrode (12) verbunden ist;
**dadurch gekennzeichnet, dass** eine dielektrische Schicht (9) an der Basis angeordnet ist und sich an dem oberen Gate (8) befindet und eine Elektrode (10) an der dielektrischen Schicht angeordnet ist;
wobei eine Kopplungskapazität durch die Elektrode (10), die dielektrische Schicht (9) und das obere Gate (8) ausgebildet ist; das obere Gate (8) potentialfrei ist und indirekt durch die Elektrode (10), die durch die dielektrische Schicht (9) beabstandet ist, gesteuert wird, und eine Gate-Elektroden-Struktur durch die Elektrode (10), die dielektrische Schicht (9) und das obere Gate (8) als Ganzes ausgebildet ist.

2. Vertikaler Sperrschicht-Feldeffekttransistor nach Anspruch 1, ferner umfassend:
einen ersten Kanal (5) des ersten Dotierungstyps, der zwischen dem oberen Gate (8) und den unteren Gates (3) ausgebildet ist, wobei sich das obere Gate (8) an dem ersten Kanal (5) befindet;
wobei eine erste JFET-Region durch das obere Gate (8) des zweiten Dotierungstyps, den ersten Kanal (5) des ersten Dotierungstyps und die unteren Gates (3) ausgebildet ist.

3. Vertikaler Sperrschicht-Feldeffekttransistor nach Anspruch 1, ferner umfassend:
einen zweiten Kanal (6) des ersten Dotierungstyps, der zwischen den zwei unteren Gates (3) ausgebildet ist;
wobei die erste JFET-Region durch das obere Gate (8) des zweiten Dotierungstyps, einen Abschnitt der Basis zwischen dem oberen Gate (8) und den unteren Gates (3) und die unteren Gates (3) ausgebildet ist; und
eine zweite JFET-Region durch die zwei unteren Gates (3) und den zweiten Kanal (6) ausgebildet ist.

4. Vertikaler Sperrschicht-Feldeffekttransistor nach einem der Ansprüche 1 bis 3, wobei innere Leitungspfade in der Basis von der Drain-Elektrode (13) zu den zwei Source-Elektroden (12) durch die Basis des ersten Dotierungstyps, einen Abschnitt unterhalb der Gate-Elektroden-Struktur zwischen den unteren Gates (3) und einen Abschnitt unterhalb der Gate-Elektroden-Struktur und zwischen dem oberen Gate (8) und den unteren Gates (3) ausgebildet sind.

5. Vertikaler Sperrschicht-Feldeffekttransistor nach einem der Ansprüche 1 bis 4, wobei der vertikale Sperrschicht-Feldeffekttransistor ein selbstsperrendes Bauelement oder ein selbstleitendes Bauelement ist.

6. Vertikaler Sperrschicht-Feldeffekttransistor nach Ansprüchen 1 bis 5, wobei das Substrat (1) aus einem von Siliziumkarbidsubstrat, Siliziumsubstrat, Diamantsubstrat oder Kaliumoxidsubstrat ausgewählt ist;
die dielektrische Schicht (9) aus Material mit hoher Dielektrizitätskonstante hergestellt ist; und
die Elektrode (10) eine polykristalline Siliziumelektrode oder Metallelektrode ist.

7. Vertikaler Sperrschicht-Feldeffekttransistor nach einem der Ansprüche 1 bis 6, ferner umfassend:
eine Metall-Silicid-Schicht (14), die zwischen dem oberen Gate (8) und der dielektrischen Schicht (9) ausgebildet ist.

8. Vertikaler Sperrschicht-Feldeffekttransistor nach einem der Ansprüche 1 bis 7, wobei eine Dotierungskonzentration des oberen Gates (8) größer oder gleich 1x10¹⁶cm⁻³ ist.

9. Vertikaler Sperrschicht-Feldeffekttransistor nach Anspruch 3, wobei eine Dotierungskonzentration des ersten Kanals (5) größer als eine Dotierungskonzentration der Basis ist; und
eine Dotierungskonzentration des zweiten Kanals (6) größer als eine Dotierungskonzentration der Basis ist.

10. Herstellungsverfahren des vertikalen Sperrschicht-Feldeffekttransistors mit einer durch vertikale Kopplungskapazität ausgebildeten Gate-Struktur, umfassend:
Ausbilden einer Basis eines ersten Dotierungstyps;
Ausbilden zweier unterer Gates (3) eines zweiten Dotierungstyps in der Basis und in seitlicher Richtung beabstandet;
Ausbilden eines oberen Gates (8) des zweiten Dotierungstyps in der Basis, wobei sich das obere Gate (8) oberhalb eines Zwischenraums zwischen den zwei unteren Gates (3) befindet und in vertikaler Richtung ein Zwischenraum zwischen dem oberen Gate (8) und den unteren Gates (3) ausgebildet ist;
Ausbilden zweier Source-Regionen (7) des ersten Dotierungstyps, die jeweils an einem der zwei unteren Gates (3) angeordnet sind, wobei die zwei Source-Regionen (7) mit einem Abschnitt der Basis zwischen dem oberen Gate (8) und den unteren Gates (3) verbunden sind;
Ausbilden zweier Source-Elektroden (12), wobei jede Source-Elektrode (12) mit einer jeweiligen Source-Region (7) verbunden ist;
Ausbilden eines Substrats (1) des ersten Dotierungstyps, wobei eine Drain-Elektrode (13) an einer unteren Oberfläche des Substrats (1) angeordnet ist; und
Ausbilden zweier ohmscher Kontaktregionen des zweiten Dotierungstyps, jeweils an einer Seite von einem der jeweiligen unteren Gates (3) angeordnet und damit verbunden;
wobei jede Source-Elektrode (12) sich an einer Grenzfläche einer Source-Region (7) und einer ohmschen Kontaktregion (4) des zweiten Dotierungstyps befindet, und jede Source-Elektrode (12) mit einer Source-Region (7) und einer ohmschen Kontaktregion (4) des zweiten Dotierungstyps verbunden ist;
wobei jedes untere Gate (3) mit einer ohmschen Kontaktregion (4) des zweiten Dotierungstyps verbunden ist, jede ohmsche Kontaktregion (4) des zweiten Dotierungstyps mit einer Source-Elektrode (12) verbunden ist;
**dadurch gekennzeichnet, dass** eine dielektrische Schicht (9) ausgebildet wird, die sich an der Basis und an dem oberen Gate (8) befindet, und eine Elektrode (10) an der dielektrischen Schicht (9) ausgebildet wird; wobei eine Kopplungskapazität durch die Elektrode (10), die dielektrische Schicht (9) und das obere Gate (8) ausgebildet wird; das obere Gate (8) potentialfrei ist und indirekt durch die Elektrode (10), die durch die dielektrische Schicht (9) beabstandet ist, gesteuert wird, und eine Gate-Elektroden-Struktur durch die Elektrode (10), die dielektrische Schicht (9) und das obere Gate (8) als Ganzes ausgebildet ist.

11. Herstellungsverfahren nach Anspruch 10, ferner umfassend:
Ausbilden eines ersten Kanals (5) des ersten Dotierungstyps zwischen dem oberen Gate (8) und den unteren Gates (3),
wobei sich das obere Gate (8) an dem ersten Kanal (5) befindet.

12. Herstellungsverfahren nach Anspruch 11, ferner umfassend:
Ausbilden eines zweiten Kanals (6) des ersten Dotierungstyps zwischen den zwei unteren Gates (3) durch Ionenimplantation.

13. Herstellungsverfahren nach einem der Ansprüche 10 bis 12, wobei die dielektrische Schicht (9) eine dielektrische Schicht aus Material mit hoher Dielektrizitätskonstante ist; und
die Elektrode (10) eine polykristalline Siliziumelektrode oder Metallelektrode ist.

## Revendications

1. Transistor à effet de champ à jonction verticale avec une structure de grille formée par une capacité de couplage vertical, comprenant :
une base d'un premier type de dopage ;
deux grilles inférieures (3) d'un second type de dopage, formées à l'intérieur de la base et espacées dans une direction latérale ;
une grille supérieure (8) du second type de dopage, formée à l'intérieur de la base, dans lequel la grille supérieure (8) est située au-dessus d'un intervalle entre les deux grilles inférieures (3), et un intervalle est formé dans la direction verticale entre la grille supérieure (8) et les grilles inférieures (3) ;
deux régions de source (7) du premier type de dopage, disposées sur les deux grilles inférieures (3) respectivement, dans lequel les deux régions de source (7) sont reliées à une partie de la base entre la grille supérieure (8) et les grilles inférieures (3) ;
deux électrodes de source (12), dans lequel chaque électrode de source (12) est reliée à une région de source respective (7) ;
un substrat (1) du premier type de dopage, dans lequel une électrode de drain (13) est disposée sur une surface inférieure du substrat (1) ; et
deux régions de contact ohmique du second type de dopage (4), chacune disposée sur un côté de l'une des grilles inférieures respectives (3) et reliée à celui-ci ;
dans lequel chaque électrode de source (12) est située sur une interface d'une région de source (7) et d'une région de contact ohmique du second type de dopage (4),
et chaque électrode de source (12) est reliée à une région de source (7) et à une région de contact ohmique du second type de dopage (4) ;
dans lequel chaque grille inférieure (3) est reliée à une région de contact ohmique du second type de dopage (4), chaque région de contact ohmique du second type de dopage (4) est reliée à une électrode de source (12) ;
**caractérisé en ce qu'**une couche diélectrique (9) est disposée sur la base et située sur la grille supérieure (8) et une électrode (10) est disposée sur la couche diélectrique ;
dans lequel une capacité de couplage est formée par l'électrode (10), la couche diélectrique (9) et la grille supérieure (8) ; la grille supérieure (8) est flottante et indirectement commandée par l'électrode (10) espacée de la couche diélectrique (9), et une structure d'électrode de grille est formée par l'électrode (10), la couche diélectrique (9) et la grille supérieure (8) en tant qu'ensemble.

2. Transistor à effet de champ à jonction verticale selon la revendication 1, comprenant en outre :
un premier canal (5) du premier type de dopage, formé entre la grille supérieure (8) et les grilles inférieures (3), dans lequel la grille supérieure (8) est située sur le premier canal (5) ;
dans lequel une première région JFET est formée par la grille supérieure (8) du second type de dopage, le premier canal (5) du premier type de dopage et les grilles inférieures (3).

3. Transistor à effet de champ à jonction verticale selon la revendication 1, comprenant en outre :
un second canal (6) du premier type de dopage, formé entre les deux grilles inférieures (3) ;
dans lequel la première région JFET est formée par la grille supérieure (8) du second type de dopage, une partie de la base entre la grille supérieure (8) et les grilles inférieures (3), et les grilles inférieures (3) ; et
une seconde région JFET est formée par les deux grilles inférieures (3) et le second canal (6).

4. Transistor à effet de champ à jonction verticale selon l'une quelconque des revendications 1 à 3, dans lequel des chemins conducteurs internes à l'intérieur de la base à partir de l'électrode de drain (13) jusqu'aux deux électrodes de source (12) sont formés par la base du premier type de dopage, une partie en dessous de la structure d'électrode de grille entre les grilles inférieures (3) et une partie en dessous de la structure d'électrode de grille et entre la grille supérieure (8) et les grilles inférieures (3).

5. Transistor à effet de champ à jonction verticale selon l'une quelconque des revendications 1 à 4, dans lequel le transistor à effet de champ à jonction verticale est un dispositif normalement éteint ou un dispositif normalement allumé.

6. Transistor à effet de champ à jonction verticale selon les revendications 1 à 5, dans lequel le substrat (1) est choisi parmi un substrat de carbure de silicium, un substrat de silicium, un substrat de diamant ou un substrat d'oxyde de potassium ;
la couche diélectrique (9) est faite d'un matériau à constante diélectrique élevée ; et
l'électrode (10) est choisie parmi l'une d'une électrode de silicium polycristallin ou d'une électrode métallique.

7. Transistor à effet de champ à jonction verticale selon l'une quelconque des revendications 1 à 6, comprenant en outre :
une couche de siliciure métallique (14), formée entre la grille supérieure (8) et la couche diélectrique (9).

8. Transistor à effet de champ à jonction verticale selon l'une quelconque des revendications 1 à 7, dans lequel une concentration de dopage de la grille supérieure (8) est plus grande que, ou égale à, 1×10¹⁶cm⁻³.

9. Transistor à effet de champ à jonction verticale selon la revendication 3, dans lequel une concentration de dopage du premier canal (5) est plus grande qu'une concentration de dopage de la base ; et
une concentration de dopage du second canal (6) est plus grande qu'une concentration de dopage de la base.

10. Procédé de fabrication du transistor à effet de champ à jonction verticale avec une structure de grille formée par une capacité de couplage vertical, comprenant :
la formation d'une base d'un premier type de dopage ;
la formation de deux grilles inférieures (3) d'un second type de dopage, à l'intérieur de la base et espacées dans une direction latérale ;
la formation d'une grille supérieure (8) du second type de dopage, à l'intérieur de la base, dans lequel la grille supérieure (8) est située au-dessus d'un intervalle entre les deux grilles inférieures (3), et un intervalle est formé dans la direction verticale entre la grille supérieure (8) et les grilles inférieures (3) ;
la formation de deux régions de source (7) du premier type de dopage, sur les deux grilles inférieures (3) respectivement, dans lequel les deux régions de source (7) sont reliées à une partie de la base entre la grille supérieure (8) et les grilles inférieures (3) ;
la formation de deux électrodes de source (12), dans lequel chaque électrode de source (12) est reliée à une région de source respective (7) ;
la formation d'un substrat (1) du premier type de dopage, dans lequel une électrode de drain (13) est disposée sur une surface inférieure du substrat (1) ; et
la formation de deux régions de contact ohmique du second type de dopage, chacune disposée sur un côté de l'une des grilles inférieures respectives (3) et reliée à celui-ci ;
dans lequel chaque électrode de source (12) est située sur une interface d'une région de source (7) et d'une région de contact ohmique du second type de dopage (4),
et chaque électrode de source (12) est reliée à une région de source (7) et à une région de contact ohmique du second type de dopage (4) ;
dans lequel chaque grille inférieure (3) est reliée à une région de contact ohmique du second type de dopage (4), chaque région de contact ohmique du second type de dopage (4) est reliée à une électrode de source (12) ;
**caractérisé par** la formation d'une couche diélectrique (9), située sur la base et sur la grille supérieure (8) et la formation d'une électrode (10) sur la couche diélectrique (9) ; dans lequel une capacité de couplage est formée par l'électrode (10), la couche diélectrique (9) et la grille supérieure (8) ; la grille supérieure (8) est flottante et indirectement commandée par l'électrode (10) espacée de la couche diélectrique (9) et une structure d'électrode de grille est formée par l'électrode (10), la couche diélectrique (9) et la grille supérieure (8) en tant qu'ensemble.

11. Procédé de fabrication selon la revendication 10, comprenant en outre :
la formation d'un premier canal (5) du premier type de dopage, entre la grille supérieure (8) et les grilles inférieures (3), dans lequel la grille supérieure (8) est située sur le premier canal (5).

12. Procédé de fabrication selon la revendication 11, comprenant en outre :
la formation d'un second canal (6) du premier type de dopage, entre les deux grilles inférieures (3) par implantation ionique.

13. Procédé de fabrication selon l'une quelconque des revendications 10 à 12, dans lequel la couche diélectrique (9) est une couche diélectrique de matériau à constante diélectrique élevée ; et
l'électrode (10) est choisie parmi l'une d'une électrode de silicium polycristallin ou d'une électrode métallique.
